# EUROPEAN PATENT SPECIFICATION

(11) **EP 2 143 763 B1**
(45) Date of publication and mention of the grant of the patent: **27.02.2013**
(21) Application number: 08738634.8
(22) Date of filing: 23.04.2008
(51) Int. Cl.: C08L 45/00, B65D 85/86, C08L 9/06, C08L 23/00, C08L 25/02, C08L 65/00, H01L 21/673

(54) **RESIN COMPOSITION AND MOLDED ARTICLE OBTAINED FROM THE COMPOSITION**
HARZZUSAMMENSETZUNG UND DARAUS ERHALTENER FORMKÖRPER
COMPOSITION DE RÉSINE ET ARTICLE MOULÉ OBTENU À PARTIR DE LA COMPOSITION

(30) Priority: 27.04.2007 JP 2007118258
(43) Date of publication of application: 13.01.2010
(73) Proprietor: Mitsui Chemicals, Inc., Tokyo 105-7117 (JP)
(72) Inventor: KANEKO, Kazuyoshi, Ichihara-shi Chiba 299-0108 (JP)
(74) Representative: HOFFMANN EITLE
(86) International application number: PCT/JP2008/001066
(87) International publication number: WO 2008/139698

(56) References cited:
- EP-A1- 0 671 433
- EP-A2- 0 361 909
- WO-A1-2006/025294
- WO-A1-2006/095511
- JP-A- 09 040 817
- JP-A- 2001 171 722
- JP-A- 2006 095 929
- MARUSHIGE H.: 'Taiden Boshizai-Kobunshi no Hyomen Kaishitsu-' KABUSHIKI KAISHA SAIWAI SHOBO 25 March 1972, pages 65 - 65, 85 - 90, XP008142123

## Description

### TECHNICAL FIELD

The present invention relates to a resin composition containing a predetermined antistatic agent and a container for storing a plate-like product selected from a semiconductor substrate, a display substrate and a recording medium substrate in a clean room or a tool for handling raw materials, intermediate products or end products in a clean room obtained from the same.

### BACKGROUND ART

A silicon wafer in a semiconductor production process, a glass substrate in a liquid-crystal panel production process, a metal disc in a hard disc production process, and the like are handled in a clean room for preventing them from contamination. In these production processes, in order to efficiently handle such substrates, various resin molded products such as a container, a tray, tweezers, and the like have been used. For example, a container for containing plural numbers of the substrates at the same time therein and for transporting the substrates froma specific process to the subsequent process in the clean room; a container for carrying out various treatments therein; and a tool such as tweezers for carrying a sheet wafer have been used.

These resin molded products used in the clean room are required to have high contamination resistance in order to prevent the molded products from being a contamination source by themselves. For example, it is important that an amount of a component to be volatilized into the air from the resin molded products is small or an amount of a component to be eluted in water or chemicals is small. In addition, it is also important that the molded products do not produce dust when they are in contact with other members.

To take a wafer carrier for example, the wafer carrier can not be avoided contact with a hard member, for example, when a silicon wafer is put into or taken out of the wafer carrier or when the carrier is transported by a robot. Therefore, in order to inhibit a generation of particles even in such a case, a resin molded product is strongly required excellent abrasion resistance. In addition, it is often that an antistatic property is imparted to a resin molded product for preventing electrical destruction of electronic apparatuses and for preventing particle adhesion. In recent years, in accordance with a miniaturization of apparatuses, the size of the particles to be controlled is getting smaller. Therefore, the demand for preventing the generation of the particles is getting much severe.

The cyclic olefin polymers have excellent chemical resistance, heat resistance, weather resistance, and the like and their molded products have satisfactory dimensional accuracy and rigidity. Therefore, the cyclic olefin polymers have been used as molded products for various applications. For example, in Patent Document 1, a resin composition prepared by mixing specific carbon fibers with a cyclic polyolefin is described. Since the resin composition has the antistatic property and even elutes few impurities, it is described as that the resin composition can be used as a material for carriers for electronic components such as IC carriers, wafer carriers. However, impact resistance and abrasion resistance of the product obtained from the resin composition are insufficient.

On the other hand, in Patent Document 2, a resin composition prepared by mixing rubber and conductive carbon fibers with a cyclic olefin polymer is described. It is described as that the resin composition can be used as a transporting tool or a wrapping material for the electronic apparatuses, IC, and the like. The molded product comprised of the resin composition is improved on impact resistance by mixing a rubber. However, the abrasion resistance thereof is still insufficient.

In Patent Document 3, a molded product for a clean room, which is comprised of a resin composition containing carbon fibers in order to reduce a value of a surface resistivity, is described. However, when the carbon fibers are added into the resin composition, an appearance of a molded product obtained from the resin composition blackens. Therefore, it is impossible to color the molded product into any hues, for example, red or blue. In addition, the molded product containing the carbon fibers has a high hardness and excellent abrasion resistance. However, a silicon wafer and the like placed in a molded product were abraded in some cases. For this reason, particles derived from materials to be placed were sometimes produced.

In Patent Document 4, a cross-linked cyclic olefin resin composition having impact resistance, which is comprised of a product obtained by reacting a cyclic olefin random copolymer containing an ethylene component and a cyclic olefin component and having a softening temperature of 70°C or higher, a soft copolymer having a glass transition temperature of 0°C or lower and an organic peroxide, is described. In Patent Document 4, it is described that the resin composition has excellent impact strength, and especially excellent low-temperature impact property. However, there is no description related to the abrasion resistance and the contamination resistance.
[Patent Document 1] Japanese Unexamined Patent Application Publication No. H7-126434 (Claims, paragraph [0016])
[Patent Document 2] Japanese Unexamined Patent Application Publication No. H7-109396 (Claims, paragraphs [0001] to [0003])
[Patent Document 3] International Publication No. 2006/025294 Pamphlet
[Patent Document 4] Japanese Unexamined Patent Application Publication No. H2-167318 (Claims, Advantage of the invention)

An object of the present invention is to provide a resin composition, from which there can be produced a molded product having excellent antistatic property, impact resistance, and abrasion resistance; and further from which there can be produced a molded product excellent in balance between abrasion resistance of a molded product and an effect of inhibiting abrasion of a contained product, and a molded product colored into any hues, and to provide a container for storing a plate-like product selected from a semiconductor substrate, a display substrate and a recording medium substrate in a clean room or a tool for handling raw materials, intermediate products or end products in a clean room obtained from the same.

Specifically, the present invention is provided with the below [1] to [17].

[1] A resin composition, which comprises
99 to 30 parts by weight of a cyclic olefin polymer (A); 1 to 70 parts by weight of a soft copolymer (B) obtained by polymerizing at least two kinds of monomers selected from the group consisting of olefins, dienes, and aromatic vinyl hydrocarbons, and having a glass transition temperature of 0°C or lower; and
relative to 100 parts by weight of the total amount of the cyclic olefin polymer (A) and the soft copolymer (B),
0.001 to 1 part by weight of a radical initiator (C),
0 to 1 part by weight of a polyfunctional compound (D) having two or more radically polymerizable functional groups in a molecule, and
0.5 to 10 parts by weight of a nonionic or anionic antistatic agent (E).

[2] The resin composition according to [1], in which the cyclic olefin polymer (A) is a cyclic olefin copolymer having one or two or more kinds of structure represented by the following general formula (1) :

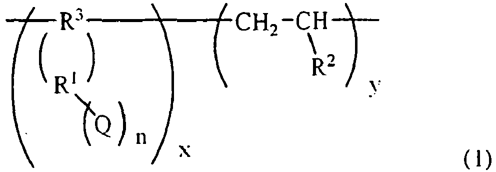

wherein, x and y represent a copolymerization ratio and are a real number satisfying 0/100 ≤ y/x ≤ 95/5, X and y are on a molar basis;
n represents a substitutional number of a substituent group Q and an integer satisfying 0 ≤ n ≤2;
R¹ is a group having a valency of 2 + n, which is selected from the group consisting of hydrocarbon groups having 2 to 20 carbon atoms, where R¹ existing in plural numbers may be the same with or different from each other;
R² is a hydrogen atom or a monovalent group selected from the group consisting of hydrocarbon groups having 1 to 10 carbon atoms which are composed of carbon atom and hydrogen atom, where R² existing in plural numbers may be the same with or different from each other;
R³ is a tetravalent group selected from the group consisting of hydrocarbon groups having 2 to 10 carbon atoms, where R³ existing in plural numbers may be the same with or different from each other;
Q is represented by -COOR⁴, where Q existing in plural numbers may be the same with or different from each other;
R⁴ is a hydrogen atom or a monovalent group selected from the group consisting of hydrocarbon groups having 1 to 10 carbon atoms which are composed of carbon atom and hydrogen atom; and
a circular arc which links R³ with R¹ represents a bond between R³ and R¹.

[3] The resin composition according to [1] or [2], in which the cyclic olefin polymer (A) has a glass transition temperature of 60 to 200°C.

[4] The resin composition according to any one of [1] to [3], in which the cyclic olefin polymer (A) is a cyclic olefin ring-opening polymer or a hydrogenation product thereof.

[5] The resin composition according to any one of [1] to [3], in which the cyclic olefin polymer (A) is a cyclic olefin copolymer having one or two or more kinds of structure represented by the following general formula (2):

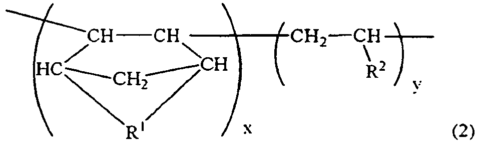

wherein, R¹ is a divalent group selected from the group consisting of hydrocarbon groups having 2 to 20 carbon atoms, where R¹ existing in plural numbers may be the same with or different from each other;
R² is a hydrogen atom or a monovalent group selected from the group consisting of hydrocarbon groups having 1 to 5 carbon atoms, where R² existing in plural numbers may be the same with or different from each other;
x and y represent a copolymerization ratio and are a real number satisfying 5/95 ≤ y/x ≤ 95/5, where x and y are on a molar basis.

[6] The resin composition according to [5], in which the cyclic olefin copolymer (A) is a copolymer comprised of tetracyclo[4.4.0.1^{2, 5}.1^{7,10}]-3-dodecene and ethylene.

[7]The resin composition according to any one of [1] to [6], in which the soft copolymer (B) is a soft copolymer obtained by polymerizing at least two kinds of monomers selected from the group consisting of ethylene and α-olefins having 3 to 20 carbon atoms.

[8] The resin composition according to any one of [1] to [7], in which the nonionic antistatic agent (E) is at least one or more kinds selected from the group consisting of polyoxyethylene alkyl ethers, polyoxyethylene alkylphenyl ethers, polyoxyethylene alkyl amines, polyoxyethylene alkyl amides, polyoxyethylene sorbitan alkyl esters, glycerin fatty acid ester, and sorbitan fatty acid ester.

[9] The resin composition according to [8], in which the nonionic antistatic agent (E) is polyoxyethylene alkyl amines.

[10] The resin composition according to [8], in which the nonionic antistatic agent (E) is glycerin fatty acid ester.

[11] The resin composition according to [9], in which the nonionic antistatic agent (E) is N,N-bis(2-hydroxy ethylene)stearyl amine.

[12] The resin composition according to any one of [1] to [7], in which the anionic antistatic agent (E) is at least one or more kinds selected from the group consisting of alkyl sulfonate, alkyl benzene sulfonate, alkyl naphthalene sulfonate, alkyldiphenyl sulfonate, alkyl phosphate ester, alkyl phosphite, alkylphosphonic acid, and alkylphosphonic acid ester.

[13] The resin composition according to any one of [1] to [12], which is prepared by melting and kneading the cyclic olefin polymer (A), the soft copolymer (B), the radical initiator (C), the polyfunctional compound (D), and the nonionic or anionic antistatic agent (E).

[14] A container for storing a plate-like product selected from a semiconductor substrate, a display substrate and a recording medium substrate in a clean room or a tool for handling raw materials, intermediate products or end products in a clean room, obtained from the resin composition according to any one of [1] to [13].

[15] The container or tool according to [14], which has a surface resistivity of 10⁸ to 10¹¹ Ω/cm².

According to the present invention, it is possible to obtain a resin composition, from which there can be produced a molded product having excellent antistatic property, impact resistance, and abrasion resistance; and further from which there can be produced a molded product excellent in balance between abrasion resistance of a molded product and an effect of inhibiting abrasion of a contained product, and a molded product colored into anv hues, and to obtain a container for storing a plate-like product selected from a semiconductor substrate, a display substrate and a recording medium substrate in a clean room or a tool for handling raw materials, intermediate products or end products in a clean room obtained from the same.

### BEST MODE FOR CARRYING OUT THE INVENTION

The present invention will be described below in detail.

### (A) Cyclic Olefin Polymer>

As for a cyclic olefin polymer (A), it is not particularly limited as long as it has the glass transition temperature described below. Specifically, a cyclic olefin polymer having one or two or more kinds of structure represented by the following general formula (1) may be used.

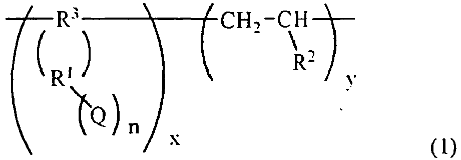

In the formula, x and y represent a copolymerization ratio and are a real number satisfying 0/100 ≤ y/x ≤ 95/5, X and y are on a molar basis;
n represents a substitutional number of a substituent group Q and an integer satisfying 0 ≤ n ≤ 2;
R¹ is a group having a valency of 2 + n, which is selected from the group consisting of hydrocarbon groups having 2 to 20 carbon atoms, where R¹ existing in plural numbers may be the same with or different from each other;
R² is a hydrogen atom or a monovalent group selected from the group consisting of hydrocarbon groups having 1 to 10 carbon atoms which are composed of carbon and hydrogen, where R² existing in plural numbers may be the same with or different from each other;
R³ is a tetravalent group selected from the group consisting of hydrocarbon groups having 2 to 10 carbon atoms, where R³ existing in plural numbers may be the same with or different from each other; and
Q is represented by -COOR⁴ (R⁴ is a hydrogen atom or a monovalent group selected from the group consisting of hydrocarbon groups having 1 to 10 carbon atoms which are composed of carbon and hydrogen), where Q existing in plural numbers may be the same with or different from each other.

In regard to each symbol in the general formula (1), there may be desirable conditions as follows and such conditions may be employed in combination according to needs.
[1] R¹ is a group having a cyclic structure in at least one site in the structure.
[2] R³ is selected from exemplified structures (a), (b) and (c) as an example (when n = 0) of a structural unit containing the R¹.

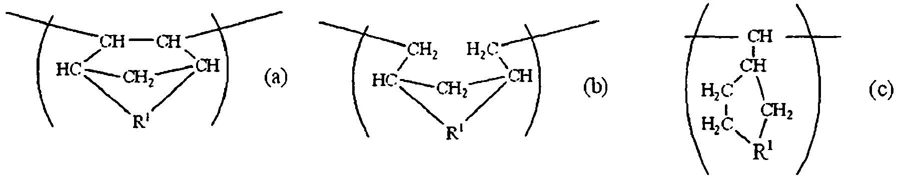

In the formula, R¹ is a group having a valency of 2 + n, which is selected from the group consisting of hydrocarbon groups having 2 to 20 carbon atoms.
[3] n is 0.
[4] y/x is a real number satisfying 5/95 ≤ y/x ≤ 95/5, and more preferably 20/80≤ y/x ≤ 65/35, respectively on a molar basis.
[5] R² is a hydrogen atom or -CH₃, where R² existing in plural numbers may be the same with or different from each other.
[6] Q is a -COOH group or a -COOCH₃ group.

As for a cyclic olefin polymer (A), it is preferably composed of one or two or more kinds of structure represented by the following general formula (2) and the desirable conditions as mentioned above may be employed in combination depending on the needs.

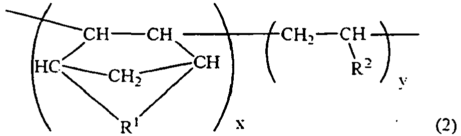

In regard to each symbol in the general formula (2), there may be, in addition, the most desirable conditions as follows and such conditions may be employed in combination depending on the needs.

[1] R¹ group is a divalent group represented by the general formula (3): 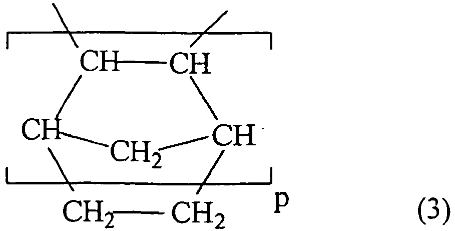 In the formula, p is an integer of 0 to 2. In addition, in regard to the general formula (3), it is preferably a divalent group in which p is 1.
[2] R² is a hydrogen atom.

Among these, as for an embodiment in which these are combined, it is preferable that a cyclic olefin polymer (A) is a polymer obtained by random additionally polymerizing ethylene and tetracyclo[4.4.0.1^{2,5}.1^{7,10}]-3-dodecene (hereinafter, abbreviated to TD).

When the cyclic olefin polymer (A) is a cyclic olefin ring-opening polymer, in regard to each symbol in the general formula (1), the following desirable conditions may be set and such conditions may be employed in combination thereof depending on the needs.
[1] R¹ is a group having a cyclic structure in at least one site of the structure.
[2] R³ contains at least the exemplified structure (b) mentioned as an example (when n = 0) of a structural unit containing the R¹.
[3] n is 0.
[4] y/x is a real number satisfying 0/100 ≤ y/x ≤ 80/20, and more preferably 0/100 ≤ y/x ≤ 50/50, respectively on a molar basis.
[5] R² is a hydrogen atom or -CH₃, where R² existing in plural numbers may be the same with or different from each other.
[6] Q is represented by -COOR⁴ (R⁴ is a hydrogen atom or a monovalent group selected from the group consisting of hydrocarbon groups having 1 to 10 carbon atoms which are composed of carbon and hydrogen), where Q existing in plural numbers may be the same with or different from each other.

The cyclic olefin ring-opening polymer, which is the cyclic olefin polymer (A), is preferably compound having of one or two or more kinds of structure represented by the following general formula (4) and the desirable conditions as mentioned above may be employed in combination thereof depending on the needs.

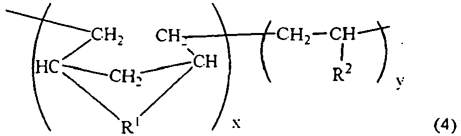

In addition, when units derived from monomers repeated x times are bonded with each other, such units are bonded with each other by a double bond.

In regard to each symbol in the general formula (4), the most preferable conditions as below may be additionally cited and such conditions may be employed in combination thereof according to needs.
[1] R¹ group is one of the following examples given.
[2] R² group is a hydrogen atom.

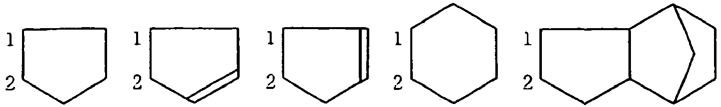

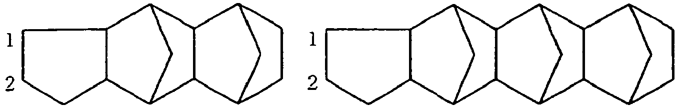

In addition, in the above examples, the carbon atom with a number 1 or 2 represents a carbon atom which bonds to a carbon atom in the general formula (4). In addition, such exemplified structures may have an alkylidene group in a part thereof. The alkylidene group is generally an alkylidene group having 2 to 20 carbon atoms. Specific examples of the alkylidene group include an ethylidene group, a propylidene group, and an isopropylidene group.

Among these, as for an embodiment in which they are used in combination, it is preferable that the cyclic olefin ring-opening polymer is a polymer obtained by a ring-opening polymerization of tricycle [4.3.0.1^{2,5}]deca-3,7-diene (dicyclopentadiene: DCPD).

When the cyclic olefin polymer (A) is a hydrogenation product of a cyclic olefin ring-opening polymer, the hydrogenation product may be obtained by saturating a part of or the whole of a double bond in the ring-opening polymer.

### (Type of Polymerization)

In the present invention, there is completely no limitation on types of the polymerization of the cyclic olefin polymer, and the known various polymerization types such as random copolymerization, block copolymerization, alternating copolymerization, ring-opening polymerization, and the like may be applied.

### (Other Structures Employable as Part of Main Chain)

In addition, if necessary, the cyclic olefin polymer used in the present invention may have a repeating structural unit derived from the other copolymerizable monomer within the range of not impairing good physical property of a substrate obtained from a resin composition of the present invention. There is no limitation on the copolymerization ratio. It is preferably 20 mol% or lower and more preferably 10 mol% or lower. When the ratio is lower than the above-mentioned numeric value, it is possible to obtain a substrate which has excellent heat resistance without impairing heat resistance. In addition, there is no limitation on the type of copolymerization, but a random copolymer is preferable.

### (Molecular Weight of Polymer)

There is no limitation on a molecular weight of the cyclic olefin polymer. When a melt flow rate (hereinafter, referred to as 'MFR') is employed as an alternative indicator for the molecular weight and is measured at the temperature of 260°C and under a load of 2.16 kg according to ASTM D1238, it is 0.5 to 100 g/10 min., more preferably 1 to 60 g/10 min. , and most preferably 5 to 40 g/10 min.

When the MFR is lower than the range, moldability deteriorates. In addition, when the MFR is higher than the range, a molded product becomes brittle. That is, when the MFR is in the above-mentioned range, a balance of moldability and hardness is excellent.

### (Glass Transition Temperature)

The cyclic olef in polymer having a glass transition temperature in the range of 60°C to 200°C is used. Among these, the cyclic olefin polymer having a glass transition temperature in the range of 100°C to 180°C is preferable. When the glass transition temperature is equal to or higher than the lower limit, it is possible to provide a molded product having excellent reliability even when the environment for using the molded product is under the high temperature condition. When the glass transition temperature is equal to or lower than the upper limit, melt moldability is excellent. That is, when the cyclic olefin polymer having the glass transition temperature in the above-mentioned range is used, a balance of properties of heat resistance and moldability is excellent.

### (Method for Producing Cyclic Olefin Polymer (A))

A method for producing the cyclic olefin polymer (A) is described by a method for producing a random copolymer, a method for producing a ring-opening polymer, and a method for producing a hydrogenation product of the ring-opening polymer.

### (Process for Producing Random Copolymer)

When the cyclic olefin polymer is a random copolymer of ethylene and cyclic olefin, the copolymer can be produced by using ethylene and the cyclic olefin represented by the following formula [I] or [II] according to the production methods disclosed in Japanese Unexamined Patent Application Publication No. H7-145213. Among those, it is preferable to produce the random copolymer of ethylene and the cyclic olefin by carrying out the copolymerization in a hydrocarbon solvent and using a catalyst, which is formed from a vanadium compound and an organoaluminium compound and is soluble in the hydrocarbon solvent, as a catalyst.

In addition, in the copolymerization reaction, a solid-phase Group 4 metallocene catalyst may be used. Herein, the solid-phase Group 4 metallocene catalyst is a catalyst comprised of a transition metal compound which contains a cyclopentadienyl skeleton-having ligand, an organoaluminiumoxy compound, and an organoaluminium compound which is combined if necessary.

The Group 4 transition metal is zirconium, titanium, or hafnium, and such transition metal has at least one cyclopentadienyl skeleton-containing ligand. Examples of the cyclopentadienyl skeleton-containing ligand include a cyclopentadienyl group or an indenyl group which may be substituted with an alkyl group, a tetrahydroindenyl group, and a fluorenyl group. These groups may bond to each other via any other groups such as an alkylene group. In addition, other ligands except the cyclopentadienyl skeleton-containing ligand are an alkyl group, a cycloalkyl group, an aryl group, an aralkyl group, and the like.

Moreover, as for the organoaluminiumoxy compound and the organoaluminium compound, the compounds generally used in producing olefin resins may be employed. In regard to the solid-phase Group 4 metallocene catalyst, it is described, for example, in Japanese Unexamined Patent Application Publication No. S61-221206, Japanese Unexamined Patent Application Publication No. S64-106, Japanese Unexamined Patent Application Publication No. H2-173112, and the like.

Examples of other monomers employable with a cyclic olefin monomer include 1-butene, 1-pentene, 1-hexene, 1-octene, 1-butene, 2-pentene, 1,4-hexadiene, cyclopentene, and the like. When such other monomers are employed, it is possible to regulate the molecular weight or physical property of the cyclic olefin polymer.

The cyclic olefin monomer represented by the following formula [I] or [II] will be described below.

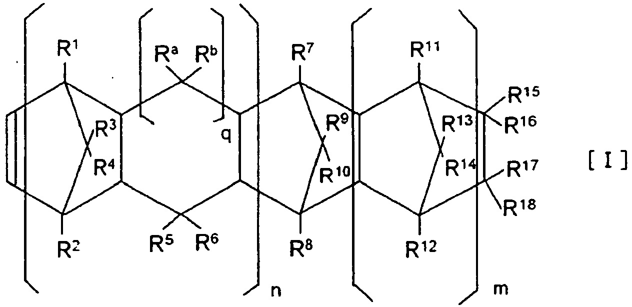

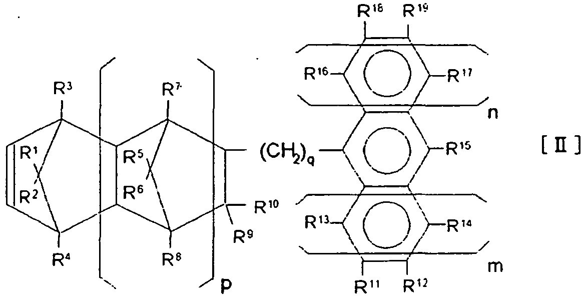

In the formula [I], n is 0 or 1; m is 0 or a positive integer; and q is 0 or 1. In addition, when q is 1, R^{a} and R^{b} each independently are the following atom or a hydrocarbon group. When q is 0, a 5-membered ring is formed.

R¹ to R¹⁸, R^{a} and R^{b} each independently are a hydrogen atom, a halogen atom, or a hydrocarbon group. The halogen atom is a fluorine atom, a chlorine atom, a bromine atom, or an iodine atom.

In addition, the hydrocarbon group is independently an alkyl group having 1 to 20 carbon atoms, a cycloalkyl group having 3 to 15 carbon atoms, or an aromatic hydrocarbon group. Specifically, examples of the alkyl group include a methyl group, an ethyl group, a propyl group, an isopropyl group, an amyl group, a hexyl group, an octyl group, a decyl group, a dodecyl group, and an octadecyl group; an example of the cycloalkyl group includes a cyclohexyl group; and examples of the aromatic hydrocarbon group include a phenyl group and a naphthyl group. The hydrocarbon group may be substituted with a halogen atom.

In addition, in the formula [I], R¹⁵ to R¹⁸ may bond to each other (or together) to form a monocyclic ring or polycyclic ring, and the monocyclic ring or polycyclic ring thus formed may have a double bond. Specific examples of the monocyclic ring or polycyclic ring to be formed herein are represented below.

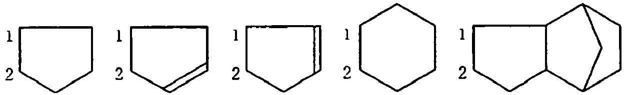

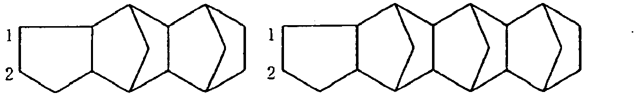

In addition, in the above examples, the carbon atom with a number 1 or 2 represents the carbon atom in the formula [I] to which R¹⁵ (R¹⁶) or R¹⁷ (R¹⁸) bonds respectively. R¹⁵ and R¹⁶, or R¹⁷ and R¹⁸ may form an alkylidene group. The alkylidene group is generally an alkylidene group having 2 to 20 carbon atoms. Specific examples of the alkylidene group include an ethylidene group, a propylidene group, and an isopropylidene group.

In the formula [II], p and q are 0 or a positive integer; m and n are 0, 1, or 2. R¹ to R¹⁹ each independently is a hydrogen atom, a halogen atom, a hydrocarbon group, or an alkoxy group.

The halogen atom has the same meaning as the halogen atom in the formula [I]. As for the hydrocarbon group, each independently, an alkyl group having 1 to 20 carbon atoms, a halogenated alkyl group having 1 to 20 carbon atoms, a cycloalkyl group having 3 to 15 carbon atoms, or an aromatic hydrocarbon group may be exemplified. More specifically, examples of the alkyl group include a methyl group, an ethyl group, a propyl group, an isopropyl group, an amyl group, a hexyl group, an octyl group, a decyl group, a dodecyl group, and an octadecyl group; an example of the cycloalkyl group includes a cyclohexyl group; and examples of the aromatic hydrocarbon group include an aryl group and an aralkyl group, specifically a phenyl group, a tolyl group, a naphthyl group, a benzyl group, a phenylethyl group, and the like. As for the alkoxy group, a methoxy group, an ethoxy group, and a propoxy group may be exemplified. Such hydrocarbon group and the alkoxy group may be substituted with a fluorine atom, a chlorine atom, a bromine atom, or an iodine atom.

Herein, the carbon atom to which R⁹ and R¹⁰ bond, and the carbon atom to which R¹³ bonds or the carbon atom to which R¹¹ bonds may bond to each other directly or via an alkylene group having 1 to 3 carbon atoms. Specifically, when the above two carbon atoms bond to each other via an alkylene group, then the groups represented by R⁹ and R¹³, or the groups represented by R¹⁰ and R¹¹ together form the alkylene group, which is one of a methylene group (-CH₂-), an ethylene group (-CH₂CH₂-), or a propylene group (-CH₂CH₂CH₂-). In addition, when n = m = 0, R¹⁵ and R¹², or R¹⁵ and R¹⁹ may bond to each other to form a monocyclic or polycyclic aromatic ring. Examples of the monocyclic or polycyclic aromatic ring in such case include the following groups in which R¹⁵ and R¹² further form an aromatic ring when n = m = 0.

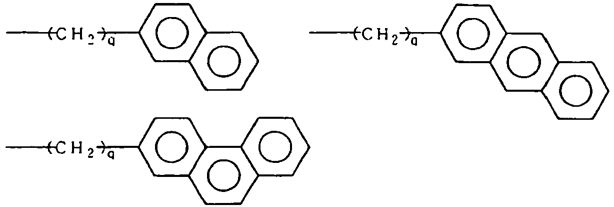

Wherein, q has the same meaning as q in the formula [II].

More specific examples of the cyclic olefinmonomer represented by the formula [I] or [II] are shown below.

For example, bicyclo[2.2.1]-2-heptene (also known as norbornene, and in the formula, the numbers of 1 to 7 each indicate the carbon position number therein) represented as below; and

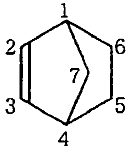

the derivatives thereof substituted with a hydrocarbon group may be exemplified.

As for the hydrocarbon group, for example, 5-methyl, 5,6-dimethyl, 1-methyl, 5-ethyl, 5-n-butyl, 5-isobutyl, 7-methyl, 5-phenyl, 5-methyl-5-phenyl, 5-benzyl, 5-tolyl, 5-(ethylphenyl), 5- (isopropylphenyl), 5- (biphenyl), 5-(β-naphthyl) , 5- (α-naphthyl ) , 5-(anthracenyl), 5,6-diphenyl, and the like may be exemplified.

Moreover, as for the other derivatives, cyclopentadiene-acenaphthylene adduct; and
bicyclo[2.2.11-2-heptene derivatives such as 1,4-methano-1,4,4a,9a-tetrahydrofluorenone,
1,4-methano-1,4,4a,5,10,10a-hexahydroanthracene, and the like may be exemplified.

In addition, also exemplified are tricyclo[4.3.0.1^{2, 5}]-3-decene derivatives such as tricyclo[4.3.0.1^{2,5}]-3-decene, 2-methyltricyclo[4.3.0.1^{2,5}]-3-decene, 5-methyltricyclo[4.3.0.1², ⁵]-3-decene, and the like;
tricycle[4.3.0.1^{2,5}]deca-3,7-diene;
tricyclo [4.4.0.1^{2,5}]-3-undecene derivatives such as tricyclo[4.4.0.1^{2,5}]-3-undecene, 10-methyltricyclo[4.4.0.1², 5]-3-undecene, and the like;
tetracyclo[4.4.0.1^{2,5}.1^{7, 10}]-3-dodecene (simply referred to tetracyclododecene, and in the formula, the numbers of 1 to 12 each indicate the carbon position number therein) represented as below;

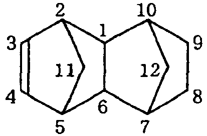

and the derivatives thereof substituted with a hydrocarbon group.

As for the hydrocarbon group, for example, 8-methyl, 8-ethyl, 8-propyl, 8-butyl, 8-isobutyl, 8-hexyl, 8-cyclohexyl, 8-stearyl, 5,10-dimethyl, 2,10-dimethyl, 8,9-dimethyl, 8-ethyl-9-methyl, 11,12-dimethyl, 2,7,9-trimethyl, 2,7-dimethyl-9-ethyl, 9-isobutyl-2,7-dimethyl, 9,11,12-trimethyl, 9-ethyl-11,12-dimethyl, 9-isobutyl-11,12-dimethyl, 5,8,9,10-tetramethyl, 8-ethylidene, 8-ethylidene-9-methyl, 8-ethylidene-9-ethyl, 8-ethylidene-9-isopropyl, 8-ethylidene-9-butyl, 8-n-propylidene, 8-n-propylidene-9-methyl, 8-n-propylidene-9-ethyl, 8-n-propylidene-9-isopropyl, 8-n-propylidene-9-butyl, 8-isopropylidene, 8-isopropylidene-9-methyl, 8-isopropylidene-9-ethyl, 8-isopropylidene-9-isopropyl, 8-isopropylidene-9-butyl, 8-chloro, 8-bromo, 8-fluoro, 8,9-dichloro, 8-phenyl, 8-methyl-8-phenyl, 8-benzyl, 8-tolyl, 8-(ethylphenyl), 8-(isopropylphenyl), 8,9-diphenyl, 8-(biphenyl), 8-(β-naphthyl), 8-(α-naphthyl), 8-(anthracenyl), 5,6-diphenyl, and the like may be exemplified.

Moreover, as for the other derivatives, adduct of acenaphthylene and cyclopentadiene, and the like may be exemplified.

In addition, pentacyclo[6.5.1.1^{3,6}.0^{2,7}.0^{9,13}]-4-pentadecene and the derivatives thereof;
pentacyclo[7.4.0.1^{2,5}.1^{9,12}.0^{8,13}]-3-pentadecene and the derivatives thereof;
pentacyclopentadecadiene compounds such as pentacyclo[6.5.1.1^{3,6}.0^{2,7}.0^{9,13}]-4,10-pentadecadiene and the like;
pentacyclo[8.4.0.1^{2,5}.1^{9,12}.0^{8,13}] -3-hexadecene and the derivatives thereof; pentacyclo[6.6.1.1^{3,6}.0^{2,7}.0^{9,14}]-4-hexadecene and the derivatives thereof;
hexacyclo[6.6.1.1^{3,6}.1^{10,13}.0^{2,7}.0^{9,14}]-4-heptadecene and the derivatives thereof;
heptacyclo[8.7.0.1^{2,9}.1^{4,7}11^{1,17}.0^{3,8}.0^{12,16}]-5-eicosene and the derivatives thereof;
heptacyclo[8.8.0.1^{2,9}.1^{4,7}.1^{11,18}.0^{3,8}.0^{12,17}]-5-heneicosene and the derivatives thereof;
octacyclo[8.8.0.1^{2,9}.1^{4,7}.1^{11,18}.0^{3,8}. 0^{12,17}]-5-docosene and the derivatives thereof;
nonacyclo[10.9.1.^{14,7}_{.}1^{13,20}.1^{15,18}.0^{2,10}.0^{3,8}.0^{12,21}.0^{14,19}]-5-pen tacosene and the derivatives thereof;
nonacyclo[10.10.1.1^{5,8}_{.}1^{14,21}.1^{16,19}.0^{2,11}.0^{4,9}.0^{13,22}.0^{15,20}]-6-he xacosene and the derivatives thereof; and the like may be exemplified.

The specific examples of the cyclic olefin monomer represented by the general formula [I] or [II] are represented above. As for more specific structure examples of these compounds, the structure examples of the cyclic olefin monomer represented in paragraphs [0032] to [0054] in the specification of Japanese Unexamined Patent Application Publication No.H7-145213 may be exemplified. A cyclic olefin resin used in the present invention may contain two or more kinds of unit derived from the above-mentioned cyclic olefin monomer.

The cyclic olefin monomer represeneted by the general formula [I] or [II] mentioned as above may be produced by the Diels-Alder reaction of cyclopentadiene with olefin having a corresponding structure. In addition, it is preferable to have a high degree of purity of the cyclic olefin monomer used in polymerization. In general, the degree of purity is equal to or higher than 99%, preferably equal to or higher than 99.6%, and more preferably equal to or higher than 99.9%.

### (Method for Producing Ring-Opening Polymer)

When the cyclic olefin polymer is a ring-opening polymer, for example, it can be produced by polymerizing or copolymerizing the cyclic olefin monomer represented by the above mentioned formula [I] in the presence of a ring-opening polymerization catalyst.

As for the cyclic olefin monomer represented by the formula [I], it is preferable to employ tricyclo[4.3.0.1^{2,5}]deca-3,7-diene.

Examples of the other monomer employable with the cyclic olefin monomer include 1-butene, 1-pentene, 1-hexene, 1-octene, 1-butene, 2-pentene, 1,4-hexadiene, cyclopentene, and the like. When such other monomers are employed, it is possible to regulate the molecular weight or physical property of the cyclic olefin polymer.

As for the ring-opening polymerization catalyst, a catalyst comprised of a halide of a metal selected from ruthenium, rhodium, palladium, osmium, indium or platinum, a nitrate or an acetylacetone compound, and a reducing agent; or a catalyst comprised of a halide of a metal selected from titanium, palladium, zirconium and molybdenum or an acetylacetone compound, and an organoaluminium compound may be employed.

The ring-opening polymer according to the present invention may be produced without using a solvent, but in general, it is preferable to produce the polymer in an inactive organic solvent. Specific examples of the organic solvent include aromatic hydrocarbons such as benzene, toluene, xylene; aliphatic hydrocarbons such as n-pentane, hexane, heptane; alicyclic hydrocarbons such as cyclohexane; halogenated hydrocarbons such as methylene dichloride, dichloroethane, dichloroethylene, tetrachroloethane, chlorobenzene, dichlorobenzene, trichlorobenzene.

### (Hydrogenation Product of Ring-Opening Polymer)

Production of a hydrogenation product of the ring-opening polymer is carried out by hydrogenating at least a part of the carbon-carbon double bonds of the ring-opening polymer according to the general method. The method for subjecting the ring-opening polymer to a hydrogenation treatment is not particularly limited, and can be carried out by subjecting the ring-opening polymer to the hydrogenation treatment in an organic solvent in the presence of a hydrogenation catalyst.

The hydrogenation reaction can be carried out according to a common method by contacting a resin composition containing the ring-opening polymer in a solution state with hydrogen in the presence of a hydrogenation catalyst. As for the hydrogenation catalyst, a homogeneous catalyst or a heterogeneous catalyst can be used. The heterogeneous catalyst has excellent production efficiency in that high activity is attained under high temperature and high pressure, it is possible to hydrogenate within a short time, it is easy to remove the catalyst, and the like.

An example of the heterogeneous catalyst includes a catalyst prepared by supporting a metal selected from the group consisting of nickel, ruthenium, rhenium, platinum, palladium, and rhodium, on a support. There is no particular limitation on the support. An adsorption agent such as alumina, diatomaceous earth, which has been so far employed in supporting hydrogenation catalyst metals, may be employed.

The amount of nickel to be supported is 20 to 80% by weight and preferably 30 to 60% by weight. The amount of palladium or platinum to be supported is 0.1 to 10% by weight and preferably 2 to 7% by weight. The form is not particularly limited, and may be powder, solid, or the like. It is desirable to use any form in accordance with the apparutus to be used.

The hydrogenation reaction according to the present invention can be carried out using any reaction containers. From the viewpoint of continuous operability, it is preferable to use a fixed-bed type reactor. The fixed-bed type reactor may be exemplified by (a) a packed tower or a shelf-plate tower type reactor; (b) a fixed-bed catalyst reactor; (c) a metal mesh or a thin layer catalyst reactor; or the like.

In the packed tower or the shelf-plate tower type reactor (a), a resin composition containing the ring-opening polymer in a solution state and hydrogen gas are subjected to cross flow contact, counter-current contact, or co-current contact in a tower packed with catalyst particles.

The fixed-bed catalyst reactor (b) can be classified to isothermal bed type, adiabatic bed type, multistage adiabatic bed type, self-heat exchanging type, external heat exchanging type, and the like. Any type may be used for the hydrogenation reaction of the present invention. A representative example of the fixed-bed catalyst reactor (b) is a reactor of the type such as that described in p. 74 in Petroleum Refining Technology and Economics by J. H. Gary and G. E. Handwerk (1975), that is, a reactor which is packed with ceramic balls on the bottom and is packed with catalyst particles in the central part of the reactor above the ceramic balls and is constituted such that a mixture of a resin composition containing a ring-opening polymer in a solution state and a gas is fed from the top plate of the reactor, and the reaction product is discharged from the bottom plate of the reactor.

The metal mesh or the thin layer catalyst reactor (c) is a reactor in which several sheets to several tens of sheets of thin layers of the metal mesh or a particulate catalyst are mounted as a catalyst. The reactor is classified into a radial flow type and a parallel flow type according to the method of running a resin composition containing a ring-opening polymer in a solution state, but any type may be used.

In regard to the method for hydrogenation according to the present invention, when a resin composition containing a ring-opening polymer in a solution state passes through the fixed-bed, it is preferable to allow the resin composition to flow over the surface of the catalyst particles in the form of film. The flow direction of the resin composition containing a ring-opening polymer in a solution state and the hydrogen gas may be co-current or counter-current, but from the viewpoint of easy modification of operating conditions, the co-current mode is preferred.

The reactor used for the method for hydrogenation according to the present invention is a reactor mounted with a fixed-bed packed with a hydrogenation catalyst. This reactor is constituted such that a resin composition containing a ring-opening polymer in a solution state is filled in the reactor, and with the catalyst packed fixed-bed being immersed with the resin composition, hydrogen is blown thereinto. The reaction is generally carried out in a batch. A representative example of the reactor includes a reactor such as that described in p. 310 in Journal of Chemical Engineering of Japan, Vol. 27, No. 3 (1994), that is, a reactor in which a cylindrical mesh basket made of stainless steel packed with catalyst particles in a frame mounted on a rotating axis is attached as a fixed-bed, and which is further equipped with a stirrer. This reactor is filled with a resin composition containing a ring-opening polymer in a solution state, and the catalyst packed basket is allowed to rotate around the rotating axis in a state of the catalyst packed basket being immersed with the resin composition. While stirring the resin composition, hydrogen gas is pressurized into the lower part of the reactor. As for an another example, it is also used a reactor in which a cage formed by packing a catalyst inside the double cylinders of a double cylindrical mesh basket as a fixed-bed is spaced at a slight gap from the inner wall of the reactor, and a stirring blade is attached to a rotating axis at the center of the double cylinder.

In regard to the method for hydrogenation according to the present invention, the resin composition containing a ring-opening polymer, which is provided for the method for hydrogenation, is a solution having a ring-opening polymer and the like dissolved in an organic solvent. This resin composition is supplied to the reactor in a solution state, and the ring-opening polymer and the like are subjected to a hydrogenation treatment. The resin composition containing a ring-opening polymer is obtained as a reaction solution after producing the ring-opening polymer, and thus it is not particularly necessary to add the organic solvent. However, the following organic solvents may be added. Such organic solvent is not particularly limited as long as it is inert to the catalyst, but from the viewpoint of excellent solubility for the hydrogenation product to be generated, hydrocarbon solvents are generally used. Examples of the hydrocarbon solvent include aromatic hydrocarbons such as benzene, toluene; aliphatic hydrocarbons such as n-pentane, hexane; alicyclic hydrocarbons such as cyclohexane, methylcyclohexane, decalin, bicyclononane; and the like. Among these, cyclic alicyclic hydrocarbons are preferable. These organic solvent can be used individually, or in combination of two or more kinds thereof. In general, the solvent may be the same as the solvent used for the polymerization reaction.

The hydrogenation reaction can be carried out according to a common method. However, depending on the type of the hydrogenation catalyst or the reaction temperature, the rate of hydrogenation varies, and the residual ratio of the aromatic ring can also be altered. In the case of using the hydrogenation catalyst described above, in order to retain the unsaturated bonds in the aromatic ring to some extent or higher, it may be controlled such as lowering the reaction temperature, decreasing the hydrogen pressure, shortening the reaction time, or the like.

The operating temperature when hydrogenating the ring-opening polymer is 0 to 150°C, preferably 60 to 130°C, and more preferably 80 to 120°C.

The pressure is 1 to 50 kg/cm², preferably 1 to 30 kg/cm², and more preferably 1 to 20 kg/cm². In addition, the reaction time, although it depends on the hydrogenation catalyst to be used, is 1 hour or shorter, and preferably 30 minutes or shorter.

The LHSV for the hydrogenation reaction is generally 1 to 10, and preferably 3 to 5. Herein, the LHSV is a reciprocal of the residence time, and can be calculated by dividing the feed flow rate of the cyclic olefin resin composition (A), which is obtained by polymerizing a cyclic olefin monomer in a hydrocarbon solvent and contains unreacted cyclic olefin monomer, by the volume of a packed catalyst.

The resin composition containing a hydrogenated ring-opening polymer, which has been discharged from the fixed-bed reactor, is introduced into a separator, such as a flash separator, to separate the resin composition and unreacted hydrogen. The separated hydrogen can be circlated to the hydrogenation reactor.

### <Soft Copolymer (B)>

A soft copolymer (B) will be described below. The soft copolymer (B) used in the present invention is obtained by polymerizing at least two or more kinds of monomers selected from the group consisting of olefin compounds, diene compounds, and aromatic vinyl hydrocarbon compounds, and has a glass transition temperature of 0°C or lower. When the obtained molded product is used for a molded product for a clean room, it is necessary that the glass transition temperature is 0°C or lower, preferably -10°C or lower, and more preferably -20°C or lower in order to sufficiently improve the abrasion resistance and inhibit a generation of particles. In general, the glass transition temperature is -100°C or higher. The degree of crystallinity of the copolymer, as measured through X-ray diffractometry, is preferably 0 to 30% and more preferably 0 to 25%.

The MFR (melt flow rate: measured at 230°C and under a load of 2.16 kg according to ASTM D1238) of the soft copolymer (B) is preferably 0.01 to 200 g/10 min. If the MFR thereof is lower than 0.01 g/10 min, then the melt viscosity of the copolymer may be too high and the melt moldability of the obtained resin composition may deteriorate. More preferably, the MFR is equal to or higher than 0.05 g/10 min, and even more preferably equal to or higher than 0.1 g/10 min. On the other hand, when the MFR is greater than 200 g/10 min, then the mechanical strength of the obtained molded product may deteriorate. More preferably, the MFR is equal to or lower than 150 g/10 min, and even more preferably equal to or lower than 100 g/10 min. In addition, it is preferable to use the copolymer having the intrinsic viscosity [η], as measured in decalin at 135°C, of 0.01 to 10 dl/g, and more preferably 0.08 to 7 dl/g.

The soft copolymer (B) is prepared by polymerizing at least two or more kinds of monomers selected from the group consisting of olefins, dienes and aromatic vinyl-hydrocarbons. It is important to use the soft copolymer (B) comprised of such monomers from the viewpoint of the affinity thereof to the cyclic olefin polymer (A). At this time, within the range of not impairing the effect of the present invention, a small amount of any other monomer than the above-mentioned monomers may be copolymerized with the copolymer.

Preferred examples of the soft copolymer (B) include the following (b1), (b2), (b3) and (b4):
(b1) : an amorphous or a low-crystalline soft copolymer prepared by polymerizing at least two or more kinds of monomers selected from the group consisting of ethylene and α-olefins having 3 to 20 carbon atoms,
(b2): a soft copolymer prepared by polymerizing ethylene, α-olefins having 3 to 20 carbon atoms and a cyclic olefin,
(b3): a soft copolymer prepared by polymerizing a non-conjugated diene and at least two or more kinds of monomers selected from the group consisting of ethylene and α-olefins having 3 to 20 carbon atoms,
(b4): a soft copolymer of a random or a block copolymer of an aromatic vinyl hydrocarbon and a conjugated diene, or the hydrogenation product thereof.

The soft copolymer (b1) is an amorphous or a low-crystalline soft copolymer prepared by polymerizing at least two or more kinds of monomers selected from the group consisting of ethylene and α-olefins having 3 to 20 carbon atoms. Among the above mentioned (b1) to (b4), the soft copolymer (b1) is particularly suitably used from the viewpoint of the affinity thereof to the cyclic olefin polymer (A).

The soft copolymer (b1) is amorphous or low-crystalline and has a glass transition temperature of 0°C or lower. Therefore, the copolymer can have flexibility. The density of the copolymer is preferably 0.85 to 0.91 g/cm³ and more preferably 0.85 to 0.90 g/cm³.

The soft copolymer (b1) is prepared by polymerizing at least two kinds of olefins, and is generally a random copolymer. Specifically, ethylene·α-olefin copolymers, propylene·α-olefin copolymers, and the like are used. Within the range of not impairing the object of the present invention, the polymer may contain, if necessary, any other copolymerizable unsaturated monomer components.

As for the α-olefin, which is the raw material for the ethylene·α-olefin copolymers, it can be exemplified by α-olefins having 3 to 20 carbon atoms, for example, propylene, 1-butene, 1-pentene, 1-hexene, 4-methyl-1-pentene, 1-octene, 1-decene, and the mixtures thereof. Among those, α-olefins having 3 to 10 carbon atoms are particularly preferable. Above all, ethylene·propylene copolymer is favorable from the viewpoint of the affinity thereof to the cyclic olefin polymer (A). The molar ratio of ethylene to α-olefin (ethylene/α-olefin) in the ethylene·α-olefin copolymer varies, depending on the type of the α-olefin therein, but is preferably 30/70 to 95/5. The molar ratio (ethylene/α-olefin) is more preferably not less than 50/50 and not more than 90/10.

In addition, as for the α-olefin, which is the raw material for the propylene·α-olefin copolymers, it can be exemplified by α-olefins having 4 to 20 carbon atoms, for example, 1-butene, 1-pentene, 1-hexene, 4-methyl-1-pentene, 1-octene, 1-decene, and the mixtures thereof. Among those, α-olefins having 4 to 10 carbon atoms are particularly preferable. The molar ratio of propylene to α-olefin (propylene/α-olefin) in the propylene·α-olefin copolymer varies, depending on the type of the α-olefin therein, but is preferably 30/70 to 95/5. The molar ratio (propylene/α-olefin) is more preferably not less than 50/50 and not more than 90/10.

The soft copolymer (b2) is a soft copolymer prepared by polymerizing ethylene, an α-olefin having 3 to 20 carbon atoms, and a cyclic olefin. The soft copolymer (b2) is prepared by polymerizing at least three kinds of olefins, and is generally a random copolymer. In addition, within the range of not impairing the object of the present invention, the copolymer may contain, if necessary, any other copolymerizable unsaturated monomer components.

As for the α-olefin having 3 to 20 carbon atoms, which is the raw material of the soft copolymer (b2), specifically it can be exemplified by propylene, 1-butene, 4-methyl-1-pentene, 1-hexene, 1-octene, 1-decene, 1-dodecene, 1-tetradecene, 1-hexadecene, 1-octadecene, 1-eicosene, and the like. One kind or two or more kinds thereof may be used. As for the cyclic olefin, which is the raw material of the soft copolymer (b2), the same olefin as that used as the raw material of the cyclic olefin polymer (A) may be used.

It is preferable that the soft copolymer (b2) is prepared by copolymerizing the monomers in a ratio of 40 to 98 mol% and preferably 50 to 90 mol% of ethylene, 2 to 50 mol% and preferably 5 to 40 mol% of the other α-olefin, and 2 to 20 mol% and preferably 2 to 15 mol% of a cyclic olefin. The structural units derived from these monomers are randomly arranged to form a substantially linear-state random copolymer. The fact that the soft copolymer (b2) is in a substantially linear-state and does not have a gel-state crosslinked structure can be confirmed by the fact that the copolymer completely dissolves in decalin at 135°C. The soft copolymer (b2) may be produced by suitably selecting the conditions according to the same method as that for the cyclic olefin polymer (A).

The soft copolymer (b3) is a soft copolymer prepared by polymerizing a non-conjugated diene, and at least two or more kinds of monomers selected from the group consisting of ethylene and α-olefins having 3 to 20 carbon atoms. The soft copolymer (b3) is prepared by polymerizing at least one kind of non-conjugated dienes and at least two kinds of olefins, and is generally a random copolymer. Specifically, ethylene·α-olefin·diene copolymer rubber, propylene·α-olefin·diene copolymer rubber, and the like are used. Within the range of not impairing the object of the invention, the copolymer may contain, if necessary, any other copolymerizable unsaturated monomer components.

As for the α-olefin constituting the ethylene·α-olefin·diene copolymer rubber, it may be exemplified by α-olefins having 3 to 20 carbon atoms, for example, propylene, 1-butene, 1-pentene, 1-hexene, 4-methyl-1-pentene, 1-octene, 1-decene, or the mixtures thereof. Among those, the α-olefins having 3 to 10 carbon atoms are particularly preferable. The molar ratio of ethylene to α-olefin (ethylene/α-olefin) in the ethylene·α-olefin·diene copolymer rubber varies, depending on the type of the α-olefin, but in general, it is preferably 30/70 to 95/5.

As for the α-olefin constituting the propylene·α-olefin·diene copolymer rubber, it may be exemplified by α-olefins having 4 to 20 carbon atoms, for example, 1-butene, 1-pentene, 1-hexene, 4-methyl-1-pentene, 1-octene, 1-decene, or the mixtures thereof. Among those, the α-olefins having 4 to 10 carbon atoms are particularly preferable. The molar ratio of propylene to α-olefin (propylene/α-olefin) in the propylene·α-olefin-diene copolymer rubber varies, depending on the type of the α-olefin, but in general, it is preferably 30/70 to 95/5.

In addition, examples of the diene component in the ethylene·α-olefin·diene copolymer rubber or the propylene·α-olefin·diene copolymer rubber include chain-state non-conjugated dienes such as 1,4-hexadiene, 1,6-octadiene, 2-methyl-1,5-hexadiene, 6-methyl-1,5-heptadiene, 7-methyl-1,6-octadiene; cyclohexadiene and dicyclopentadiene; cyclic non-conjugated dienes such as methyltetrahydroindene, 5-vinylnorbornene, 5-ethylidene-2-norbornene, 5-methylene-2-norbornene, 5-isopropylidene-2-norbornene, 6-chloromethyl-5-isopropenyl-2-norbornene; 2,3-diisopropylidene-5-norbornene; 2-ethylidene-3-isopropylidene-5-norbornene; 2-propenyl-2,2-norbornadiene; and the like. It is preferable that the content of the diene component in the copolymer is 1 to 20 mol% and preferably 2 to 15 mol%.

The soft copolymer (b4) is a random or a block copolymer of an aromatic vinyl-hydrocarbon and a conjugated diene, or the hydrogenation product thererof.

As for the soft copolymer (b4), specifically, styrene·butadiene block copolymer rubber, styrene·butadiene·styrene block copolymer rubber, styrene·isoprene block copolymer rubber, styrene·isoprene·styrene block copolymer rubber, hydrogenated styrene·butadiene·styrene block copolymer rubber, hydrogenated styrene·isoprene·styrene block copolymer rubber, styrene·butadiene random copolymer rubber, and the like may be used.

In regard to the soft copolymer (b4), in general, the molar ratio of the aromatic vinyl hydrocarbon to the conjugated diene (aromatic vinyl hydrocarbon/conjugated diene) is preferably 10/90 to 70/30. The hydrogenated styrene·butadiene·styrene block copolymer rubber is a copolymer rubber prepared by hydrogenating a part or the whole part of the double bonds remaining in the styrene·butadiene·styrene block copolymer rubber. In addition,the hydrogenated styrene·isoprene·styrene block copolymer rubber is a copolymer rubber prepared by hydrogenating a part or the whole part of the double bonds remaining in the styrene·isoprene·styrene block copolymer rubber.

The above-mentioned soft copolymers (b1), (b2), (b3) and (b4) may be used alone or in combination of two or more kinds thereof.

### <Radical Initiator (C)>

As for a radical initiator (C), it is preferable that it is capable of generating a radical through thermal decomposition under heat during melt kneading, and the types thereof is not particularly limited. The initiator may be exemplified by peroxides, azo compounds, and redox initiators, and the like. However, those containing a metal are not always favorable for molded products for a clean room since the metal residue may be mixed in the molded products. In addition, nitrogen element-containing compounds such as azo compounds may be often unfavorable since a nitrogen-containing compound may vaporize away from the molded products. Accordingly, organic peroxides are favorably employed. It is preferable that the radical initiator (C) decomposes at a suitable speed during melt kneading, and the temperature at which the one minute half-life period temperature is preferably 30 to 250°C. More preferably, the temperature at which the half-life period becomes one minute is not less than 50°C and not more than 200°C.

As for the organic peroxides usable for the radical initiator (C), it may be exemplified by ketone peroxides such as methyl ethyl ketone peroxide, cyclohexanone peroxide, and the like;
peroxyketals such as 1,1-bis(t-butylperoxy)cyclohexane, 2,2-bis(t-butylperoxy)octane, and the like;
hydroperoxides such as t-butylhydroperoxide, cumenehydroperoxide, 2,5-dimethylhexane-2,5-dihydroxyperoxide, 1,1,3,3-tetramethylbutylhydroperoxide, and the like;
dialkyl peroxides such as di-t-butyl peroxide, 2,5-dimethyl-2,5-bis(t-butylperoxy)hexane, 2,5-dimethyl-2,5-bis(t-butylperoxy)hexyne-3, and the like;
diacyl peroxides such as lauroyl peroxide, benzoyl peroxide, and the like;
peroxy esters such as t-butylperoxy acetate, t-butylperoxy benzoate, 2,5-dimethyl-2,5-bis(benzoylperoxy)hexane, and the like; and the like.

### <Polyfunctional Compound (D)>

Examples of a polyfunctional compound (D) having at least two or more of radically polymerizable functional groups in the molecule include divinylbenzene, vinyl acrylate, vinyl methacrylate, triallyl isocyanurate, diallyl phthalate, ethylene dimethacrylate, trimethylolpropane trimethacrylate, and the like.

A resin composition used for the molded product of the present invention is prepared by melt-kneading the cyclic olefin polymer (A), the soft copolymer (B), the radical initiator (C), and an antistatic agent (E). At this time, when the polyfunctional compound (D) having at least two or more of radically polymerizable functional groups in the molecule is additionally added to these raw materials and melt-kneaded, it is possible to attain more efficient crosslinking. Accordingly, abrasion resistance of the molded product may be improved.

### <Antistatic Agent (E)>

As for an antistatic agent (E) used in the present invention, a nonionic antistatic agent or an anionic antistatic agent may be used.

The nonionic antistatic agent has excellent heat resistance and compatibility with the resin.

As for the nonionic antistatic agent, it may be exemplified by polyoxyethylene alkylethers, polyoxyethylelealkyl phenol ethers, polyoxyethylene alkyl amines, polyoxyethylene alkyl amides, polyoxyethylene sorbitan alkyl esters, glycerin fatty acid esters, sorbitan fatty acid esters, and the like. These nonionic antistatic agents may be used alone or in combination of two or more kinds thereof. In the present invention, it is preferable to use polyoxyethylene alkyl amines and glycerin fatty acid esters.
As for the polyoxyethylene alkyl amines, N,N-bis(2-hydroxyethyl)alkyl amine may be exemplified and more specifically, N,N-bis(2-hydroxyethyl)stearyl amine may be exemplified. The compound is often called as N,N-bis(2-hydroxyethylene)stearyl amine.
Specific examples of the glycerin fatty acid esters include glycerin monostearate, glycerin monobehenate, glycerin monopalmitate, and glycerin monolaurylate.
In addition, as for examples of another nonionic antistatic agent, polyoxyethylene alkyl ether and polyoxyethylene alkylphenyl ether may be exemplified.

As for the anionic antistatic agent, it may be exemplified by sulfonate type antistatic agents such as alkyl sulfonate, alkyl benzene sulfonate, alkyl naphthalene sulfonate, alkyl diphenyl sulfonate, and the like; phosphorus-containing type antistatic agents such as alkyl phosphate ester, alkyl phosphite, alkylphosphonic acid, alkylphosphonic acid ester, and the like; and the like. These anionic antistatic agents may be used alone or in combination of two or more kinds thereof. In the present invention, it is preferable to use alkyl sulfonate.
The alkyl sulfonate having generally 8 to 24 carbon atoms is preferably used.

The resin composition of the present invention comprises 99 to 30 parts by weight of the cyclic olefin polymer (A); 1 to 70 parts by weight of the soft copolymer (B); and
relative to 100 parts by weight of the total amount of the cyclic olefin polymer (A) and the soft copolymer (B), 0.001 to 1 part by weight of the radical initiator (C), 0 to 1 part by weight of the polyfunctional compound (D), and 0.5 to 10 parts by weight of the nonionic or the anionic antistatic agent (E).

The amount of the soft copolymer (B) to be mixed is 1 to 70 parts by weight. When the amount of the soft copolymer (B) to be mixed is smaller than 1 part by weight, abrasion resistance could not be improved sufficiently. The amount is preferably not less than 3 parts by weight. On the other hand, when the amount of the soft copolymer (B) to be mixed is greater than 70 parts by weight, rigidity of the obtained molded product may be decreased and the molded product may be difficult to be used for a clean room. The amount is preferably not more than 60 parts by weight. That is, the amount of the soft copolymer (B) to be mixed is 1 to 70 parts by weight, preferably 3 to 60 parts by weight, and more preferably 5 to 50 parts by weight.
When the amount of the soft copolymer (B) to be mixed is in the above-mentioned range, abrasion resistance of the molded product is improved and further rigidity of the molded product is retained. Therefore, the molded product can be suitably used for a clean room.

The amount of the radical initiator (C) to be mixed is 0.001 to 1 part by weight relative to 100 parts by weight of the total amount of the cyclic olefin polymer (A) and the soft copolymer (B). When the amount of the radical initiator (C) to be mixed is smaller than 0.001 parts by weight, the crosslinking reaction does not sufficiently proceed, with the result that abrasion resistance does not be improved sufficiently. The amount is preferably not less than 0.01 parts by weight. On the other hand, when the amount of the radical initiator (C) to be mixed is greater than 1 part by weight, the amount of the gas release may increase and the contamination resistance may deteriorate. The amount is preferably not more than 0.5 parts by weight. That is, the amount of the radical initiator (C) to be mixed is preferably 0.01 to 0.5 parts by weight and more preferably 0.05 to 0.2 parts by weight, relative to 100 parts by weight of the total amount of the cyclic olefin polymer (A) and the soft copolymer (B).
When the amount of the radical initiator (C) to be mixed is in the above-mentioned range, it is possible to obtain the molded product of which abrasion resistance is improved and which has excellent contamination resistance.

The amount of the polyfunctional compound (D) to be mixed is 0 to 1 part by weight relative to 100 parts by weight of the total amount of the cyclic olefin polymer (A) and the soft copolymer (B). Mixing the polyfunctional compound (D) is optional, and it may not be mixed to the composition. However, for efficiently carrying out the crosslinking reaction, it is preferable to mix the compound. In that case, the amount to be mixed is preferably not less than 0.001 parts by weight and more preferably not less than 0.01 parts by weight. On the other hand, when the amount of the polyfunctional compound (D) to be mixed is greater than 1 part by weight, the amount of the gas release may increase and the contamination resistance may deteriorate. The amount is preferably not more than 0.5 parts by weight. That is, the amount of the polyfunctional compound (D) to be mixed is preferably 0.01 to 0.5 parts by weight and more preferably 0.05 to 0.2 parts by weight, relative to 100 parts by weight of the total amount of the cyclic olefin polymer (A) and the soft copolymer (B).
When the amount of the polyfunctional compound (D) to be mixed is in the above-mentioned range, it is possible to obtain the molded product of which impact resistance and abrasion resistance is improved and which has excellent contamination resistance.

The amount of the antistatic agent (E) to be mixed is 0.5 to 10 parts by weight relative to 100 parts by weight of the total amount of the cyclic olefin polymer (A) and the soft copolymer (B). When the amount of the antistatic agent (E) to be mixed is smaller than 0. 5 parts by weight, the antistatic effect becomes insufficient. The amount is preferably not less than 1 part by weight. On the other hand, when the amount of the antistatic agent (E) to be mixed is greater than 10 parts by weight, the amount of the gas release may increase and the contamination resistance of the molded product may deteriorate. The amount is preferably not more than 8 parts by weight. That is, the amount of the antistatic agent (E) to be mixed is preferably 1 to 8 parts by weight and more preferably 2 to 7 parts by weight, relative to 100 parts by weight of the total amount of the cyclic olefin polymer (A) and the soft copolymer (B).
When the amount of the antistatic agent (E) to be mixed is in the above-mentioned range, it is possible to obtain the molded product which has excellent antistatic performance and excellent contamination resistance.

The resin composition of the present invention contains 99 to 30 parts by weight of the cyclic olefin polymer (A); 1 to 70 parts by weight, preferably 3 to 60 parts by weight, and more preferably 5 to 50 parts by weight of the soft copolymer (B); and relative to 100 parts by weight of the total amount of the cyclic olefin polymer (A) and the soft copolymer (B), the radical initiator (C), the polyfunctional compound (D), and the nonionic or the anionic antistatic agent (E) in the following amounts:
radical initiator (C): 0.001 to 1 part by weight, preferably 0.01 to 0.5 parts by weight, and more preferably 0.05 to 0.2 parts by weight;
polyfunctional compound (D) : 0 to 1 part by weight, preferably 0.01 to 0.5 parts by weight, and more preferably 0.05 to 0.2 parts by weight; and
nonionic or anionic antistatic agent (E) : 0. 5 to 10 parts by weight, preferably 1 to 8 parts by weight, and more preferably 2 to 7 parts by weight;
In addition, such range of values may be optionally combined.

From the resin composition of the present invention having the above-mentioned compositions, there can be produced a molded product which has excellent properties such as heat resistance, chemical resistance, strong-acid resistance, strong-alkaline resistance, impact resistance, dimensional stability and antistatic property, and abrasion resistance which makes possible to inhibit the generation of particles (dusts) which is problematic in a clean room; and which can be colored into any hues. In addition, from the resin composition of the present invention, there can be produced a molded product which is excellent in balance between abrasion resistance and an effect of inhibiting abrasion of a contained product. Therefore, the generation of particles (dusts) can be effectively inhibited. Since the molded product of the present invention has such excellent properties, it can be suitably used for various molded products, especially for a container and a tool, usable in the clean room.

In addition to these antistatic agents (E), as for the other components, heat-resistant stabilizer, weather-resistant stabilizer, slipping agent, antiblocking agent, antifogging agent, lubricant, dye, pigment, natural oil, synthetic oil, wax, organic or inorganic filler, and the like may be mixed. However, in consideration of the fact that a release of volatile components and soluble components and generation of particles are harmful to the molded product for the clean room, it is desirable that the amount of these additives is kept to the minimum.

A molded product obtained from the resin composition of the present invention having such compositions can be suitable used as a molded product for a clean room. That is, the resin composition of the present invention can be suitably used as a resin composition for a molded product for a clean room.

For coloring a molded product, the generally known methods may be applied. In coloring, a dye or a pigment is generally used, and a pigment is preferably used.
A dye is generally called as oil color and melted in a solvent. Therefore, it is possible to have excellent dispersibility and high transparent color. However, the dye has color transitivity which causes bleeding or blooming so that it is required to regulate the amount of the dye to be used to a minimum amount.
A pigment is an insoluble fine particle in water or a solvent, and is provided for coloring in a state where the pigment is dispersed in plastics. The pigment can be broadly divided into an organic pigment and an inorganic pigment.

So far, for coloring plastics, heavy metals such as cadmium-based, chrome-based, and lead-based inorganic pigment, which are low-cost and have excellent heat resistance, weather resistance, permanent chromatic, transition resistance and dimensional stability, have been used. However, problem in production of such pigments, problem in usage thereof, influence thereof on the human body from a molded product, and problem in waste product has been closed up. Therefore, the inorganic pigments containing heavy metals, especially cadmium are avoided. Recently, the organic pigment is greatly used.

The organic pigments such as quinacridone, phthalocyanine, diketopyrrolopyrrole, dioxazine, isoindolinone, perylene have properties such as light resistance, heat resistance, transition resistance, vivid hue, high coloring power.

For the improvement of compatibility between the pigment and a resin, there has been known a method for surface modification as so-called pigment derivatives in which a substituent group is introduced to the pigment structure. For example, it can be exemplified by phthalimidemethyl derivatives described in Japanese Examined Patent Application Publication No. S53-7185 and the like.
In addition, as for the method for surface modification of the pigment except that the pigment derivatives, a surface treatment by organic silane or organic titanium and a surface coating by a thermoplastic resin are carried out. For example, in Japanese Unexamined Patent Application Publication No.H05-194873, there is a description that a surface of a pigment is modified by a polymer by coexisting a sulfonic acid having an organic pigment residue and a polymer comprised of water soluble polymeric ammonium salt.

A method for producing the resin composition of the present invention will be described below. The resin composition may be obtained by melt-kneading the cyclic olefin polymer (A), the soft copolymer (B), the radical initiator (C), and the antistatic agent (E). It is considered that when the cyclic olefin polymer (A) and the soft copolymer (B) are melt-kneaded at a temperature at which the radical initiator (C) decomposes, the both may be crosslinked with each other to obtain a molded product having excellent abrasion resistance. At this time, it is preferable to add the polyfunctional compound (D) along with the radical initiator (C). Accordingly, it is possible to proceed the crosslinking reaction more effectively.

When such components are mixed, all these raw materials may be mixed at the same time. However, it is preferable to employ a method of melt-kneading the cyclic olefin polymer (A) and the soft copolymer (B) in advance, and then adding the radical initiator (C) thereto and further melt-kneading the mixture. Because, since the crosslinking reaction is started at the state where the cyclic olefin polymer (A) and the soft copolymer (B) have been fully blended according to above mentioned, a resin composition having excellent dispersibility is obtained.

When the cyclic olefin polymer (A), the soft copolymer (B), and the radical initiator (C) are melt-kneaded, the melt viscosity of the resin composition to be obtained may increase according to the crosslinking reaction progress. Therefore, it may cause a problem when a molding method that requires high-level melt flowability is employed. For example, when a resin composition is injection-molded at a high speed, or when a resin composition is injection-molded to obtain a large-size molded product, or when a resin composition is injection-molded to obtain a molded product that requires severe dimensional accuracy, desired molded products may not be obtained.

In such cases, it is desirable that the cyclic olefin polymer (A) is added to the mixture separately two times. That is, it is preferable to employ a method of melt-kneading a part of the cyclic olefin polymer (A) and the soft copolymer (B) in advance, adding the radical initiator (C) thereto and melt-kneading the mixture, and further adding the residual cyclic olefin polymer (A) thereto and melt-kneading the mixture. Accordingly, the mixture of the cyclic olefin polymer (A) and the soft copolymer (B), which has a crosslinked structure, can be diluted with the cyclic olefin polymer (A) not having a crosslinked structure, and melt viscosity of the composition may be prevented from increasing. According to the method, it is possible to sufficiently improve abrasion resistance. The ratio of the amount of the cyclic olefin polymer (A) to be added in advance to the amount thereof to be added subsequently (advance/subsequence) is not particularly limited. It is preferably 1/99 to 70/30. When the ratio (advance/subsequence) is smaller than 1/99, abrasion resistance of the resin composition may deteriorate. The ratio is preferably not less than 5/95. On the other hand, when the ratio (advance/subsequence) is greater than 70/30, the effect of preventing the increase in melt viscosity may deteriorate. The ratio is more preferably not more than 50/50.

In the present invention, in addition to the above-mentioned raw materials, the nonionic or the anionic antistatic agent (E) is melt-kneaded with them. At this time, the antistatic agent (E) may be added thereto anytime. When the cyclic olefin polymer (A), the soft copolymer (B), and the radical initiator (C) are mixed, antistatic agent (E) may be simultaneously added thereto. However, it is preferable that antistatic agent (E) is added thereto after the three components of the cyclic olefin polymer (A), the soft copolymer (B), and the radical initiator (C) are melt-kneaded in advance. Because dispersibility of each component may be improved, thereby the physical properties such as moldability, abrasion resistance and mechanical strength may be improved. At this time, when the cyclic olefin polymer (A) is added to the mixture separately two times in the manner mentioned above, the antistatic agent may be added thereto along with the latter part of the cyclic olefin polymer (A) to be added thereto, or may be added thereto still after the addition. In the same manner, any other filler than antistatic agent (E) may be added to the mixture.

The cyclic olefin polymer (A), the soft copolymer (B), the radical initiator (C) and the antistatic agent (E) may be melt-kneaded at any temperature at which the cyclic olefin polymer (A) and the soft copolymer (B) can be melted and the radical initiator (C) can be decomposed. Specifically, the temperature is preferably 150 to 350°C. For more efficiently proceeding the crosslinking reaction, the kneading temperature is preferably not lower than 200°C. In addition, for preventing any excess thermal decomposition of the resin, the kneading temperature is preferably not higher than 300°C. It is preferable to use a radical initiator (C) having a half-life period of not longer than 1 minute at the kneading temperature.

The apparatus for using in melt-kneading is not specifically limited. Various kneading apparatuses, for example, a single-screw extruder, a twin-screw extruder, a roll, a Banbury mixer, and the like may be used for melt-kneading. Among them, it is preferable to use an extruder, especially a multi-screw extruder such as a twin-screw extruder that enables sufficient kneading. When an extruder is used, it is preferable to improve the kneading performance thereof by arranging not only a regular screw but also a kneading disc, a reverse screw, or the like. Thus melt-kneaded resin composition may be directly supplied to molding as it is, or may be once pelletized and then supplied to melt-molding.

When the cyclic olefin polymer (A), the soft copolymer (B), and the radical initiator (C) are reacted, generation of decomposition products derived from the radical initiator or the resin is not avoided. Some of these decomposition products are volatile, and in consideration of the contamination resistance of the molded products, it is preferable to effectively remove the products. Accordingly, when the cyclic olefin polymer (A), the soft copolymer (B), and the radical initiator (C) are melt-kneaded, it is desirable to use an extruder equipped with a vent. In that manner, the volatile components may be removed through the vent. The type of the vent is not specifically limited, and it maybe an atmospheric vent. However, a vacuum vent is preferably used for more efficiently removing the volatile components. At this time, when a multi-screw extruder such as a twin-screw extruder is used, it enables sufficient kneading and improves the efficiency of removing the volatile components.

At this time, it is preferable that the time for which the melted product after addition of the radical initiator (C) thereto stays in the extruder is 30 to 1,800 seconds. The time means an overall time after the addition of the radical initiator (C) and before the production of a molded product, for which the mixture stays in the extruder equipped with a vent. Accordingly, when two extruders are used, the time is a total of these residence times. When one extruder is used and the radical initiator (C) is added thereto during the kneading, the time means the residence time taken to pass through the downstream from the position of adding. The residence time may be calculated by dividing the inner capacity of the extruder by the discharging speed. When the residence time is too short, the removal of volatile components may be unsatisfactory. The time is more preferably not shorter than 60 seconds and even more preferably not shorter than 120. On the other hand, when the residence time is too prolonged, the production efficiency may deteriorate. Therefore, the time is preferably not longer than 1,500 seconds and even more preferably not longer than 1,200 seconds.

The MFR (measured in accordance with ASTM D1238, at 230°C, and under a load of 2.16 kg) of the resin composition thus obtained is preferably 0.01 to 100 g/10 min. When the MFR thereof is lower than 0.01 g/10 min. , it is often difficult to carry out melt-molding, especially injection-molding. The MFR is more preferably not lower than 0.02 g/10 min and even more preferably not lower than 0.05 g/10 min On the other hand, when the MFR is higher than 100 g/10 min., strength or abrasion resistance of the molded product may deteriorate. The MFR is more preferably not higher than 80 g/10 min and even more preferably not hither than 60 g/10 min.

The obtained resin composition is melt-molded to produce a molded product. The molding method is not specifically limited, but injection-molding is preferable. The injection-molding condition is not specifically limited. However, the following conditions are represented as for the preferable conditions.
· Cylinder Set Temperature:
   180 to 340°C, more preferably 200 to 320°C.
· Maximum Injection Speed:
   100 to 240 ml/sec., more preferably 120 to 180 ml/sec.
· Injection Set Pressure:
   100 to 250 MPa, more preferably 150 to 220 MPa.
· Mold Temperature:
   30 to 140°C, more preferably 30 to 80°C.

The injection speed (ml/sec) is a value obtained by multiplying the injection set speed of a screw by the cross section area of the screw. The injection speed may be often varied during injection operations, and in the present invention, the maximum value of the injection speed in one injection operation is referred to as a maximum injection speed (ml/sec). Molded products for a clean room have a complicated three-dimensional form and require dimensional accuracy. In addition, many of the molded products have a relatively large size. Accordingly, the molded products are preferably injection-molded at a maximum injection speed over a certain level. On the other hand, when the maximum injection speed is too high, the resin may decompose due to the shear heat thereof so that attention is required.

It is preferable that when it is heated at 150°C for 30 minutes, the overall amount of the gas release from the thus obtained molded product of the present invention is not more than 20 µg/g in terms of hexadecane. When the amount of the gas release is small as mentioned above, it is possible to prevent the clean room from being contaminated. The overall amount of the gas release is more preferably not higher than 15 µg/g and even more preferably not higher than 10 µg/g.

In addition, the molded product obtained from the resin composition of the present invention has the surface resistivity of 10⁸ to 10¹¹ Ω/cm². When the surface resistivity thereof is not higher than 10¹¹ Ω/cm², particle adhesion can be prevented. The surface resistivity is preferably not higher than 10¹⁰ Ω/cm².

Since the molded product of the present invention has the above-mentioned properties, it can be suitably used for a molded product for a clean room. In regard to the molded product for the clean room, there is no particular limitation thereto as long as it is a molded product usable in a clean room. It can be exemplified by containers, trays, tools, and the like for handling raw materials, intermediate products, or final products in the clean room.

A preferred embodiment of the invention is a container for storing a plate-like product selected from a semiconductor substrate, a display substrate, and a recording medium substrate obtained from the inventive resin composition. The plate-like product as referred to herein includes not only the large dimensional ones but also chips obtained by cutting them. Among such plate-like products, a container for a semiconductor substrate that requires severe level of management is a particularly preferred embodiment. At this time, the container may be in direct contact with the plate-like product therein, or may further contain another container that is in direct contact with the plate-like product therein.

Another preferred embodiment of the invention is a tool for handling raw materials, intermediate products, or end products obtained from the inventive resin composition. Since such tool is often in direct contact with the raw materials, the intermediate products, or the end products, the inventive tool is greatly advantageous. As for the tool, for example, tweezers and the like may be exemplified. The materials to be handled by the tool are not specifically limited. The tool may be used for handling articles of various forms, such as plate-like product, blocks, containers, and the like. Among these, a tool for handling plate-like product selected from a semiconductor substrate, a display substrate, and a recording medium substrate is preferable. In addition, a tool for handling a semiconductor substrate that requires severe level of management is particularly preferable.

As for the semiconductor substrate, a substrate for production of integrated circuits, a substrate for production of solar cells, and the like may be exemplified. The typical raw material of the substrate is silicon, but is not specifically limited. In addition, the form of the substrate may be circular such as silicon wafers, or may be square-like such as solar cells. In addition, the form may also be chip-like form obtained by cutting silicon wafers.

Among those, one typical embodiment is a container for silicon wafers. The container for a clean room of the present invention that releases little gas and generates few particles is favorable for storing silicon wafers. In recent, the diameter size of silicon wafers is enlarging, and according to such enlargement, the size of the container for the silicon wafers is also enlarging. Accordingly, with upsizing thereof, the molded products as a whole shall require severe level of dimensional accuracy. Therefore, the container for the clean room of the present invention that may be molded with good dimensional accuracy is preferable.

At this time, when a container referred to as a carrier in which silicon wafers are directly arranged, the silicon wafers are in direct contact with the carrier, contamination is especially problematic and there may occur cross-contamination via a processing solution used. Accordingly, the container for the clean room of the present invention is preferable for such carrier. In addition, the container for the clean room of the invention is also preferably used for a container referred to as a case or a box, where the carrier is stored therein, as well as for an integrated container that serves both as a carrier and as a case.

As for the display substrate, a substrate for production of liquid crystal displays, a substrate for production of plasma displays, a substrate for production of electroluminescent (EL) displays, and the like may be exemplified. The typical raw material for such substrate is glass, but may be any others, for example, a transparent resin and the like. Since contamination control is important in the case of these display substrates, it is preferable to employ the container for the clean room of the present invention. In addition, there are especially many large-size display substrates. For that reason, it is preferable to use the container for the clean room of the present invention which has excellent dimensional accuracy.

In addition, as for the recording medium substrate, a hard disc substrate and an optical disc substrate may be exemplified. When the substrate is the hard disc substrate, the material thereof is typically metal or glass, but is not limited thereto. In addition, when the substrate is the optical disc substrate, the material thereof is typically a transparent plastic represented by polycarbonate, but is not limited thereto. In regard to these recording media, the composition of the recording film varies depending on the recording form thereof. With the recent striking improvement in the recording density in these media, even a minor contaminant may have a significant influence on the properties of the recording media. Therefore, the container for the clean room of the present invention is suitably used for the substrates.

### EXAMPLES

The present invention will be described in detail with reference to the following Examples. However, the invention is not limited to these Examples. In the invention, each physical property was measured according to the following methods.

### (1) Melt Flow Rate (MFR)

In accordance with ASTM D1238, a MFR of a cyclic olefin polymer was measured at the temperature of 260°C and under a load of 2.16 kg. The MFR of Zeonor, which is the cyclic olefin polymer, was measured at the temperature of 280°C and under a load of 2.16 kg. The MFR of a propylene polymer was measured at the temperature of 230°C and under a load of 2.16 kg. The MFR of a resin composition was measured at the temperature of 260°C and under a load of 2.16 kg.

### (2) Glass Transition Temperature (Tg)

The glass transition temperature was measured by using DSC-20 manufactured by SEIKO Electronic Industry Co. , Ltd. at a temperature increasing rate of 10°C/min.

### (3) Overall Amount of Gas Release

An angular plate-like molded product having a size of 120 mm x 130 mm obtained by injection molding was placed at a room temperature for 24 hours. After that, the article was placed under the conditions in that at 23°C, under humidity of 50% RH, and for not shorter than 6 hours to be provided for measurement. After weighing around 1.0 g of a sample, the sample was enclosed to a vial bottle (10 ml) for a headspace sampler. The vial bottle was set for sampler, and heated at 150°C for 30 minutes, whereupon the generated gas was analyzed according to a static headspace method and GC-MS. As for an apparatus, Headspace Sampler (G1888, manufactured by Agilent Technologies) and GC-MS (HP6890/HP5973, manufactured by Hewlett Packard) were respectively used. As for the GC-MS conditions, a column (DB-17MS) was used, a temperature increasing rate was 10°C/min (40°C for 1 min → 280°C for 10 min), Helium gas was used as a carrier gas, and a flow rate was 0.7 ml/ min. For an identification analysis, a search software of the GC apparatus was used to select a compound having high match rate. For the quantification of a detected peak, the conversion quantification was carried out by using toluene as a standard sample.

### (4) Taber Abrasion

The abrasion amount of a sample was measured in accordance with JIS K7204. An angular plate-like molded product having a size of 120 mm x 130 mm obtained by injection molding was placed at a room temperature for 24 hours. After that, the article was provided for a test. As for an abrasion tester, Taber abrasion test apparatus T410 (manufactured by Toyo Seiki Co.) was used. The abrasion wheel was CS17, a load was 1,000 g (500 g in one arm), and the rotation number was 1,000.

### (5) Silicone Wafer Abrasion Property on Scratch (Wafer Abrasion)

An angular plate-like molded product having a size of 120 mm x 130 mm obtained by injection molding was placed at a room temperature for 24 hours. After that, the article was provided for a test. The molded product of sample was kept in contact with the outer periphery of a silicon wafer having a diameter of 200 mm, and a load of 500 g was applied thereto; and in that condition, the molded product was slid back and forth against the silicon wafer for a distance of 30 mm for 5,000 cycles of sliding. The sliding direction was vertical to the wafer face, and the wafer face and the test face of the molded product were kept vertical to each other; and in that condition, the molded product was kept slid for 2 hours. As for the silicon wafer, an 8-inches wafer (thickness: 725 ± 25 µm) manufactured by Wacker NSCE Co. was used. As for the test apparatus, a shuttle abrasion tester TYPE-305 (manufactured by Shinto Chemical Co.) was used. After the test, the degree of abrasion was evaluated according to a gloss variation and abrasion width.
· Gloss Variation = |Gloss before abrasion - Gloss after abrasion|
· Abrasion Width; From the minimum width of the abrasion width to the maximum width thereof in the shuttle sliding part (30 mm) was measured.

### (6) Surface Resistivity

An angular plate-like molded product having a size of 120 mm x 130 mm and a thickness of 2 mm obtained by injection molding was placed at a room temperature for 24 hours. After that, the article was placed under the conditions in that at 23°C, under humidity of 50% RH, and for not shorter than 6 hours to be provided for measurement. The measurement was carried out in accordance with JIS K6911 by applying an applied voltage of 500 V. As for the apparatus, a ultrahigh-resistance micro current meter (R8340A, manufactured by Advantest) was used.

### (7) HDT (Deflection Temperature under load)

In accordance with ASTM D648, the HDT was measured under the following conditions: at a temperature increasing rate of 2°C/ min and under a test stress of 1.814 MPa. For the HDT measurement, a full automatic HDT tester 6A2 Type (manufactured by Toyo Seiki Co.) was used.

### (8) Izod Impact Strength

In accordance with ASTM D256, the strength was measured under the following conditions: at 23°C, using 40 kgf of hammer, and in the presence of notch. For the Izod impact strength, Izod Impact Tester DG-UB (manufactured by Toyo Seiki Co.) was used.

### (9) Appearance

To confirm the possibility of coloring, an angular plate having a thickness of 2 mm, a length of 120 mm, and a width of 130 mm molded by injection molding was used to confirm the appearance. It was determined that there was no problem in the case that deep color was not found on visual reference.

### (Standard)

Level 1: Coloring is possible in appearance.
Level 2: Few coloring is found in appearance and it is possible to newly color.
   However, a color to be colored is limited.
Level 3: Coloring is found in appearance, and it is impossible to newly color.

### [Example 1]

50 parts by weight of (A) a random copolymer of ethylene and tetracyclo[4.4.0.1^{2,5}.1^{7,10}]-3-dodecene (ethylene·tetracyclododecene random copolymer) having a glass transition temperature of 145°C and a MFR of 10 g/10 min., and 50 parts by weight of (B) an ethylene·propylene random copolymer (manufactured by Mitsui Chemicals Inc., TAFMER P-0680) having a MFR of 0.7 g/10 min and an ethylene content of 80 mol% were thoroughly mixed. After that, the mixture was melt-kneaded using a twin screw extruder (manufactured by Japan Steel Works, Ltd., 'TEX-44') at a cylinder temperature of 250°C, and was pelletized through a pelletizer to obtain a 'pellet a'.

The twin screw extruder used herein has L/D of 42, and has vents at the tip of the cylinder. Each vent is opened to the air. The screw constitution is mainly a regular screw, but before and after the vents at around the center, a kneading disc is disposed.

To the above 'pellet a', 0.05 parts by weight of the radical initiator (C) having 2,5-dimethyl-2,5-bis(t-butylperoxy)hexyne-3 (manufactured by Nippon Oil and Fats Co., Ltd., 'Perhexyne 25B') as a main component (not less than 90%), and 0.1 parts by weight of divinylbenzene (manufactured by Wako Pure Chemical Industries) as for the polyfunctional compound (D) were added and thoroughly mixed. The mixture was inserted to the above-mentioned twin screw extruder, 'TEX-44' (cylinder temperature of 250°C), andmelt-kneaded and reacted. The mixture was pelletized through a pelletizer to obtain a 'pellet b'.

20 parts by weight of the above 'pellet b' and 80 parts by weight of (A) a random copolymer of ethylene and tetracyclo [4.4.0.1², ⁵.1^{7,10}]-3-dodecene (ethylene·tetracyclododecene random copolymer) having a glass transition temperature of 145°C and a MFR of 10 g/10 min were thoroughly mixed. The mixture was melt-kneaded using the above-mentioned twin screw extruder, 'TEX-44', at the cylinder temperature of 250°C. The mixture was pelletized through a pelletizer to obtain a 'pellet c'.

To the above 'pellet c', 2 parts by weight of nonionic N,N-bis(2-hydroxy ethylene)stearyl amine (manufactured by Lion Corporation, 'Amostat 310') as the antistatic agent (E) was added and thoroughly mixed. The mixture was inserted to the above-mentioned twin screw extruder, 'TEX-44', and melt-kneaded. After that, the mixture was pelletized through a pelletizer to obtain a 'pellet d'.

The MFR of the obtained 'pellet d' was measured (in accordance with ASTM D1238 and under a load of 2.16 kg) at 260°C and it was 10.9 g/10 min. In addition, the overall amount of gas release was 6.6 µg/g.

By using an injection molding machine (manufactured by Toshiba Machine Plastic Engineering, 'IS55EPN'), the obtained 'pellet d' was injection-molded to produce each plate for measuring each physical property, and a test piece.

Each physical property is as follows: the amount of abrasion loss on Taber abrasion was 23.2 mg; the gloss variation on wafer abrasion was 8; the abrasion width was 2.12 to 2.33 mm; the value of surface resistivity was 3.470E + 09 Ω/cm²; the HDT was 112°C; the Izod impact strength was 61 J/m; and the appearance of the molded product was level 1. In addition, the value of surface resistivity after 30 days later was 3. 370E + 09 Ω/cm², and there was no variation with the time and it was stable. The results are shown in Table 1.

By using the 'pellet d', a 200 mm wafer carrier was molded by an injection molding machine (manufactured by Japan Steel Works, Ltd., 'J450E-C5'). The diameter of the screw in the injection molding machine was 76 mm, and the molding condition was as follows: the cylinder set temperature was 260°C, the mold set temperature was 30°C, the maximum injection set speed of the screw was 31 mm/sec. (the maximum injection speed of the resin composition: 141 ml/sec.), and the injection set pressure was 200 MPa. The obtained wafer carrier had satisfactory moldability.

### [Example 2]

In the same manner as in Example 1, except that 5 parts by weight of the antistatic agent (E) was used, a pellet was obtained and evaluated. The results are shown in Table 1.

### [Example 3]

In the same manner as in Example 1, except that 5 parts by weight of nonionic stearyl monoglyceride (Kao Corporation, electro stripper TS-5) as for the antistatic agent (E) was used, a pellet was obtained and evaluated. The results are shown in Table 1.

### [Example 4]

In the same manner as in Example 1, except that a (A) cyclic olefin polymer (Zeonor 1600, manufactured by Japan Zeon Corporation), which is obtained by ring-opening polymerization, having a glass transition temperature of 162°C and a MFR (ASTM D1238, at a temperature of 260°C, under a load of 2.16 kg) of 7 g/10 min., and 5 parts by weight of nonionic stearyl monoglyceride (Kao Corporation, Electrostripper TS-5) as the antistatic agent (E) were used, a pellet was obtained and evaluated. The results are shown in Table 1.

### [Example 5]

In the same manner as in Example 1, except that 5 parts by weight of the anionic antistatic agent (Kao Corporation, Electrostripper PC-3) as the antistatic agent (E) was used, a pellet was obtained and evaluated. The results are shown in Table 1.

### [Comparative Example 1]

In the same manner as in Example 1, except that 90 parts by weight of (A) a random copolymer of ethylene and tetracyclo[4.4.0.1^{2, 5}.1^{7, 10}] -3-dodecene (ethylene·tetracyclododecene random copolymer) having a glass transition temperature of 105°C and a MFR of 26 g/10 min. ; 10 parts by weight of (B) an ethylene·propylene random copolymer (manufactured by Mitsui Chemicals Inc., TAFMER P-0880) having a MFR of 0.4 g/10 min and an ethylene content of 80 mol%; 0.1 parts by weight of the radical initiator (C); and 10 parts by weight of a carbon fiber as the antistatic agent (E) were used, a pellet was obtained and evaluated. The results are shown in Table 2.

### [Comparative Example 2]

In the same manner as in Example 1, except that 5 parts by weight of an amphoteric betaine compound (manufactured by Sanyo Chemical Industries, Ltd., Chemistat 4700) as the antistatic agent (E) was used, a pellet was obtained and evaluated. The results are shown in Table 2.

### [Comparative Example 3]

In the same manner as in Example 1, except that the antistatic agent (E) was not used, a pellet was obtained and evaluated. The results are shown in Table 2.

### [Comparative Example 4]

In the same manner as in Example 1, except that the soft copolymer (B), the radical initiator (C), and the polyfunctional compound (D) were not used, and the amounts of the ethylene·tetracyclododecene random copolymer (A) and the antistatic agent (E) to be mixed were changed, a pellet was obtained and evaluated. The results are shown in Table 2.

### [Comparative Example 5]

In the same manner as in Example 1, except that 80 parts by weight of (A) high density polyethylene (PE Hi-Zex 2200J manufactured by Prime Polymer Co., Ltd.) having a MFR of 5.2 g/10 min., and 20 parts by weight of (B) ethylene·propylene random copolymer (manufactured by Mitsui Chemicals Inc., TAFMER P-0680) having a MFR of 0.7 g/10 min and an ethylene content of 80 mol% were used, and the antistatic agent (E) was not used, a pellet was obtained and evaluated. The results are shown in Table 2.

### [Comparative Example 6]

In the same manner as in Example 1, except that the soft copolymer (B) was not used, and the amount of the ethylene·tetracyclododecene random copolymer (A) to be mixed was changed, a pellet was obtained and evaluated. The results are shown in Table 2.

### [Comparative Example 7]

In the same manner as in Example 1, except that the radical initiator (C) was not used, a pellet was obtained and evaluated. The results are shown in Table 2.

### [Comparative Example 8]

In the same manner as in Example 1, except that (A) a cyclic olefin polymer (Zeonor 1600, manufactured by Japan Zeon Corporation), which is obtained by ring-opening polymerization, having a glass transition temperature of 162°C and a MFR of 7 g/10 min was used, and the antistatic agent (E) was not used, a pellet was obtained and evaluated. The results are shown in Table 3.

### [Comparative Example 9]

In the same manner as in Example 1, except that 100 parts by weight of a polypropylene homopolymer (PP J105GZ, manufactured by Prime Polymer Co., Ltd.) as the (A) was used, the soft copolymer (B), the radical initiator (C), and the polyfunctional compound (D) were not used, and further the amount of the antistatic agent (E) to be mixed was changed, a pellet was obtained and evaluated. The results are shown in Table 3.

### [Comparative Example 10]

In the same manner as in Example 1, except that 100 parts by weight of a polypropylene block polymer (PP J705UG, manufactured by Prime Polymer Co., Ltd.) as the (A) was used, the soft copolymer (B), the radical initiator (C), and the polyfunctional compound (D) were not used, and further the amount of the antistatic agent (E) to be mixed was changed, a pellet was obtained and evaluated. The results are shown in Table 3.

### [Comparative Example 11]

In the same manner as in Example 1, except that 100 parts by weight of polybutylene terephthalate (PBT310, manufactured by Japan GE Plastics Ltd.) as the (A) was used, the soft copolymer (B), the radical initiator (C), and the polyfunctional compound (D) were not used, and further the amount of the antistatic agent (E) to be mixed was changed, a pellet was obtained and evaluated. The results are shown in Table 3.

### [Comparative Example 12]

In the same manner as in Example 1, except that 15 parts by weight of the antistatic agent (E) was used, a pellet was obtained and evaluated. The results are shown in Table 3. Since the used amount of the antistatic agent was too much, when the mixture was melt-kneaded, the predetermined amount thereof could not be added thereto thereby bleeding out. Therefore, the physical properties were not evaluated.

### [Comparative Example 13]

In the same manner as in Example 1, except that 0.1 parts by weight of the antistatic agent (E) was used, a pellet was obtained and evaluated. The results are shown in Table 3.

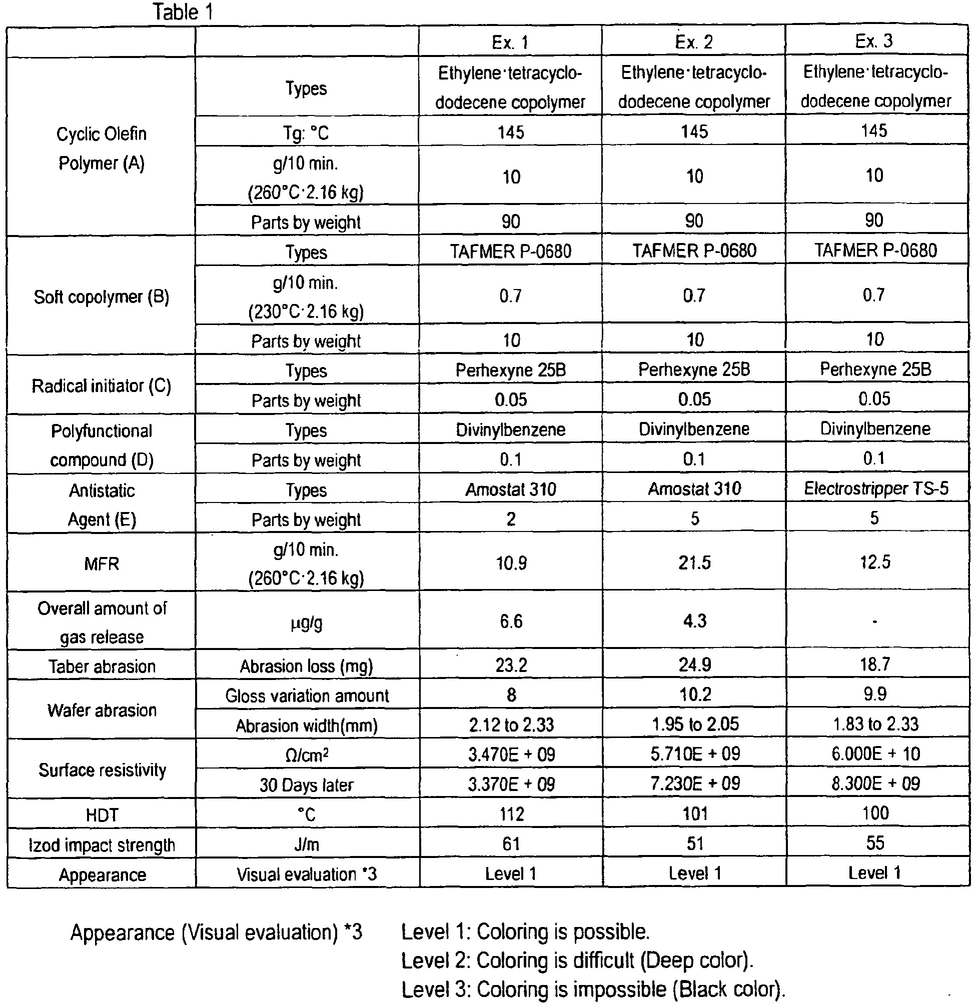

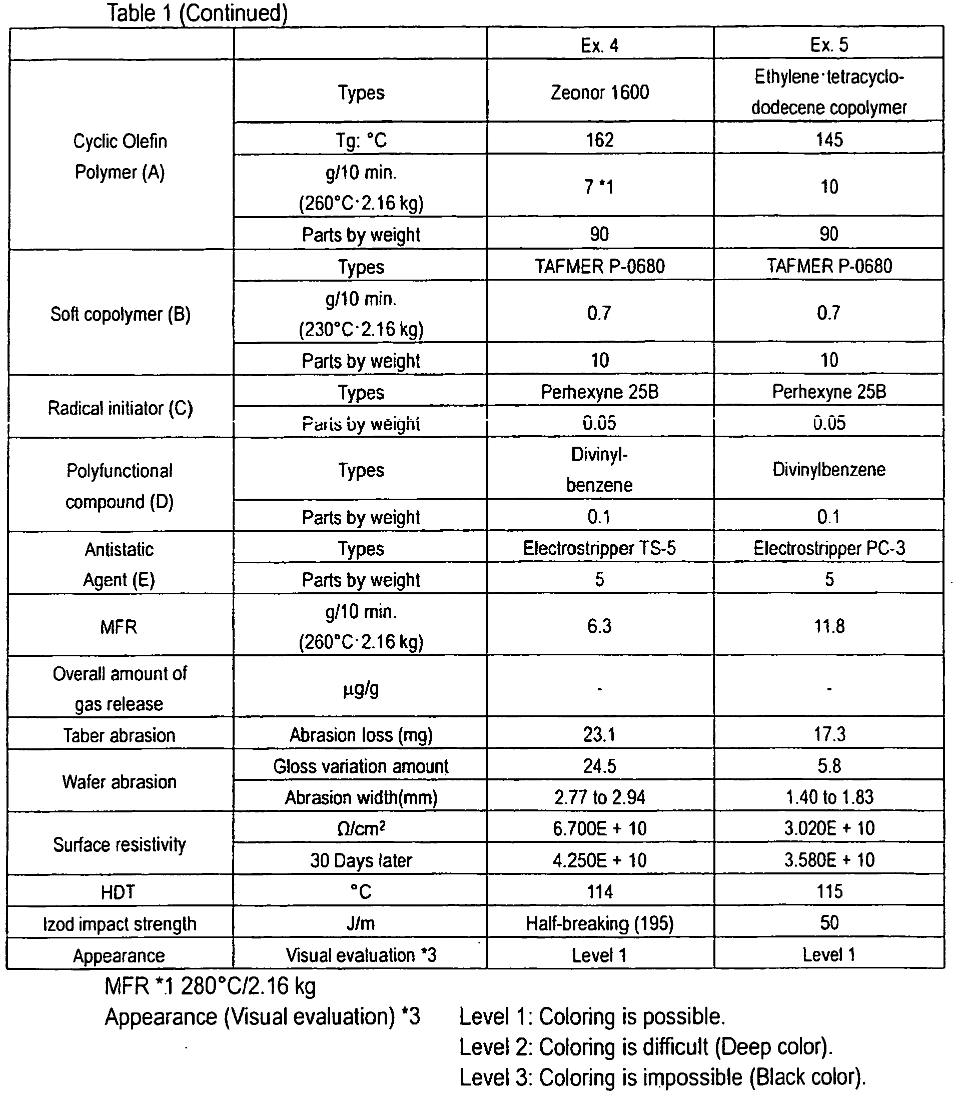

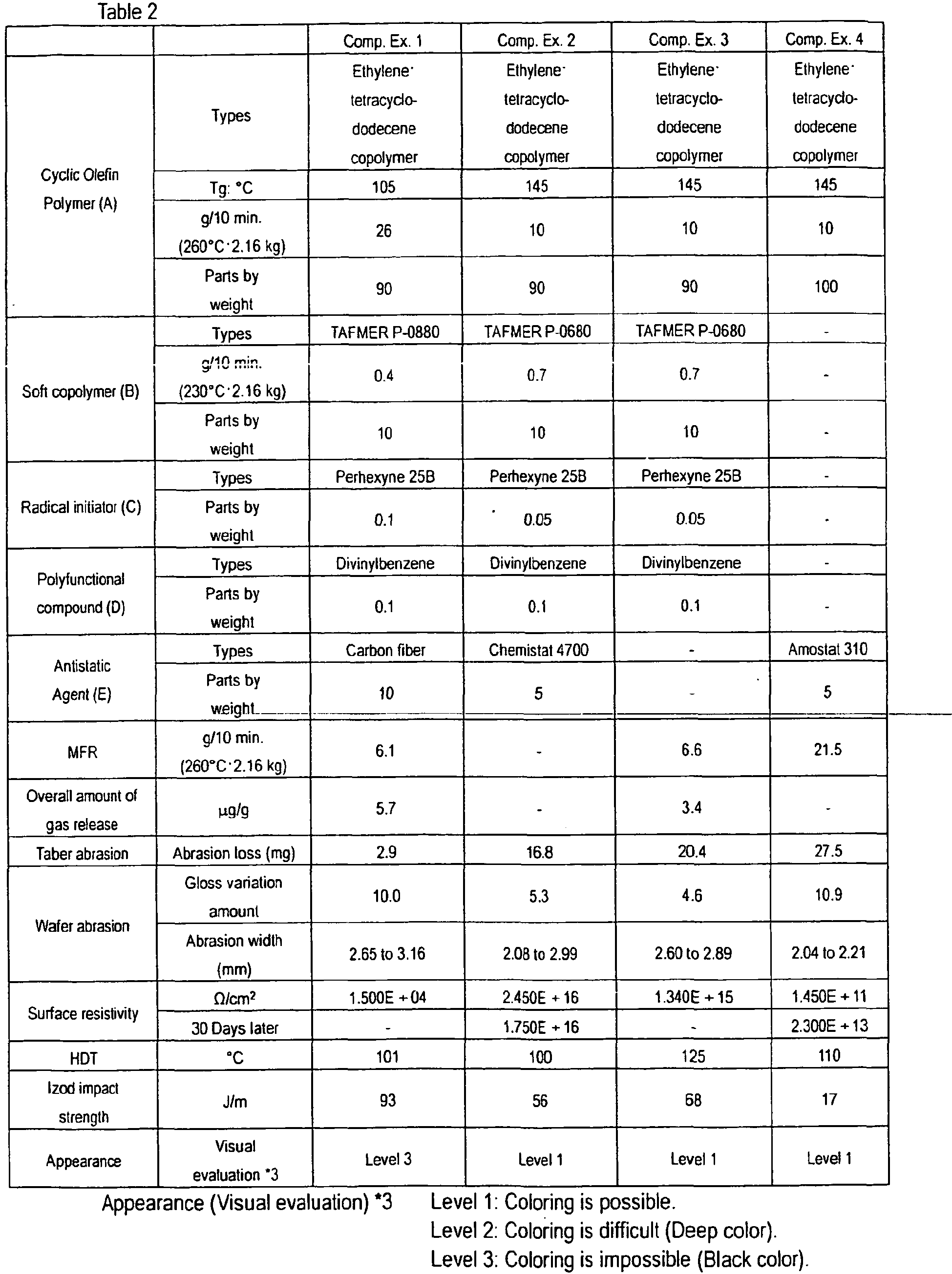

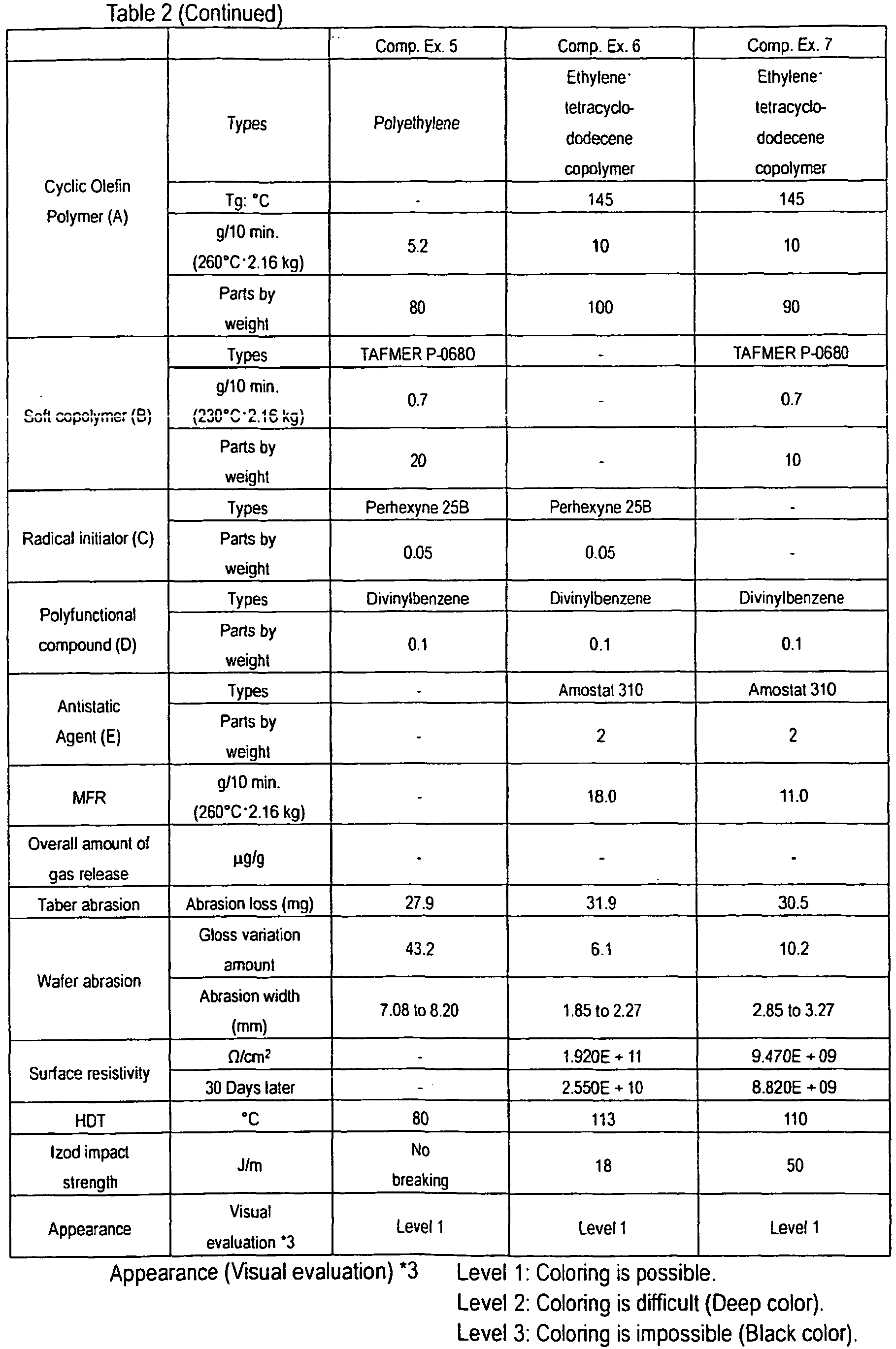

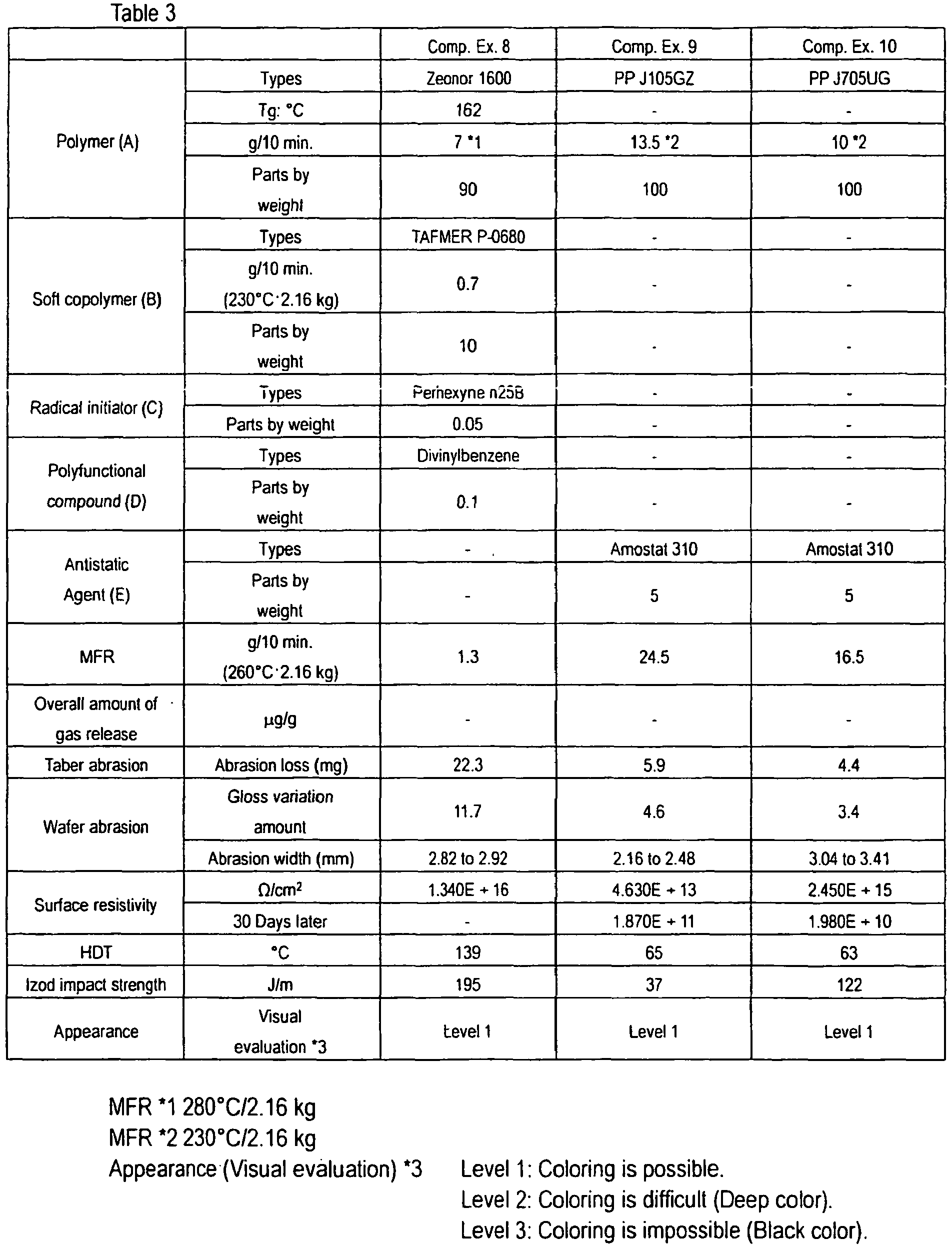

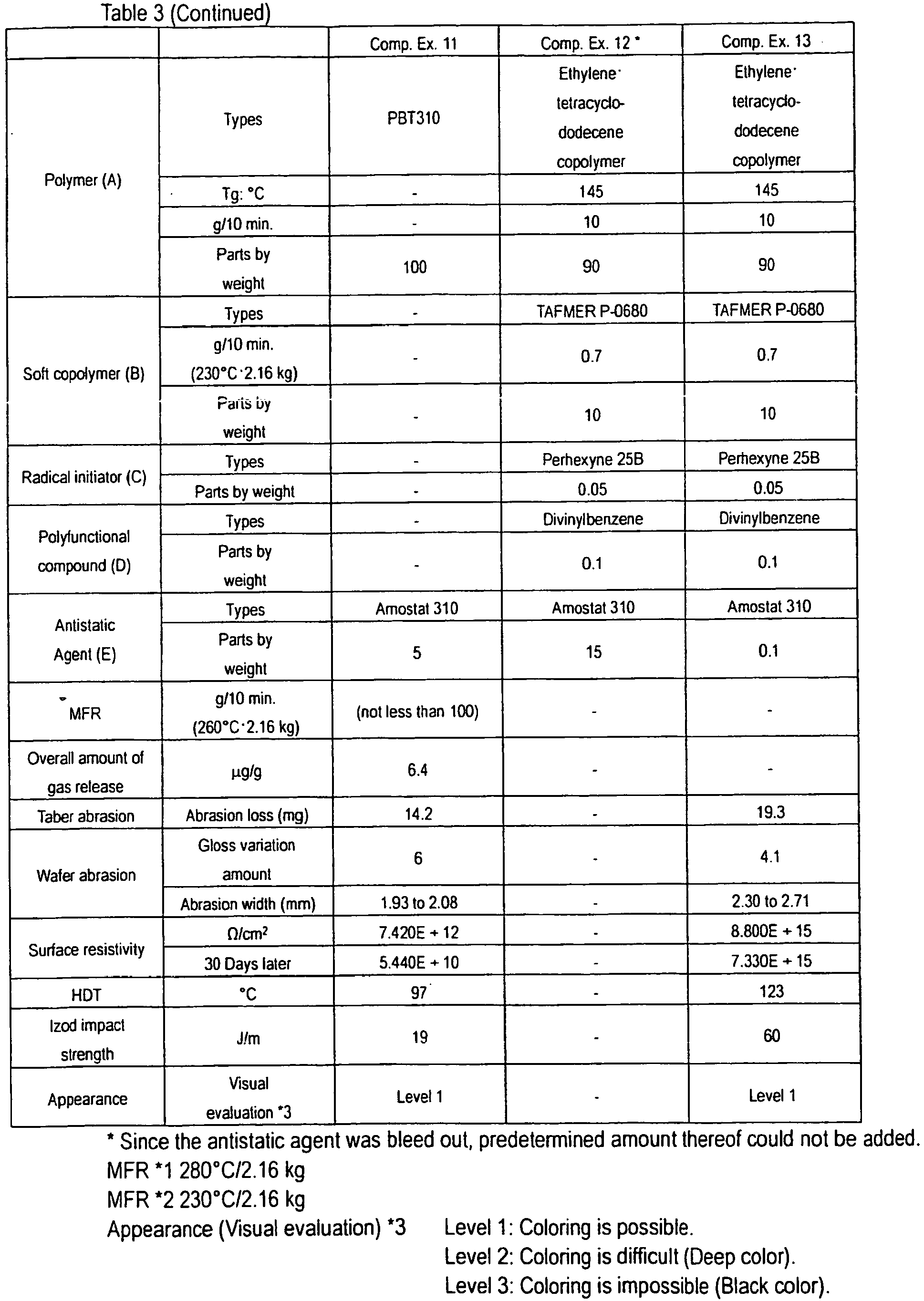

According to such results, it is confirmed that from a resin composition of the present invention, there can be produced a molded product which has excellent abrasion resistance, impact resistance, and antistatic property, and further excellent balance between abrasion resistance of a molded product and an effect of inhibiting abrasion of a contained product, and which can be colored into any hues. In addition, it is confirmed that the molded product of the present invention is suitably used for a container for a clean room, such as a wafer carrier or the like.

## Claims

1. A resin composition comprising:
99 to 30 parts by weight of a cyclic olefin polymer (A);
1 to 70 parts by weight of a soft copolymer (B) obtained by polymerizing at least two kinds of monomers selected from the group consisting of olefins, dienes, and aromatic vinyl hydrocarbons, and having a glass transition temperature of 0°C or lower; and
relative to 100 parts by weight of the total amount of the cyclic olefin polymer (A) and the soft copolymer (B),
0.001 to 1 part by weight of a radical initiator (C),
0 to 1 part by weight of a polyfunctional compound (D) having two or more radically polymerizable functional groups in a molecule, and
0.5 to 10 parts by weight of a nonionic or anionic antistatic agent (E).

2. The resin composition according to Claim 1,
wherein the cyclic olefin polymer (A) is a cyclic olefin copolymer having one or two or more kinds of structure represented by the following general formula (1): 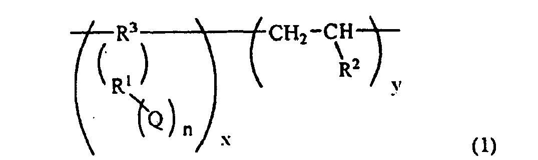 wherein, x and y represent a copolymerization ratio and are a real number satisfying 0/100 ≤ y/x ≤ 95/5, X and y are on a molar basis;
n represents a substitutional number of a substituent group Q and an integer satisfying 0 ≤ n ≤ 2;
R¹ is a group having a valency of 2 + n, which is selected from the group consisting of hydrocarbon groups having 2 to 20 carbon atoms, where R¹ existing in plural numbers may be the same with or different from each other;
R² is a hydrogen atom or a monovalent group selected from the group consisting of hydrocarbon groups having 1 to 10 carbon atoms which are composed of carbon atom and hydrogen atom, where R² existing in plural numbers may be the same with or different from each other;
R³ is a tetravalent group selected from the group consisting of hydrocarbon groups having 2 to 10 carbon atoms, where R³ existing in plural numbers may be the same with or different from each other;
Q is represented by -COOR⁴, where Q existing in plural numbers may be the same with or different from each other;
R⁴ is a hydrogen atom or a monovalent group selected from the group consisting of hydrocarbon groups having 1 to 10 carbon atoms which are composed of carbon atom and hydrogen atom; and
a circular arc which links R³ with R¹ represents a bond between R³ and R¹.

3. The resin composition according to Claim 1 or 2, wherein the cyclic olefin polymer (A) has a glass transition temperature of 60 to 200°C.

4. The resin composition according to any one of Claims 1 to 3,
wherein the cyclic olefin polymer (A) is a cyclic olefin ring-opening polymer or a hydrogen additive thereof.

5. The resin composition according to any one of Claims 1 to 3,
wherein the cyclic olefin polymer (A) is a cyclic olefin copolymer having one or two or more kinds of structure represented by the following general formula (2): 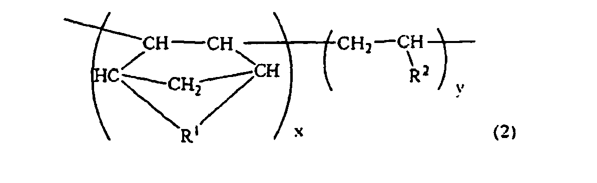 wherein, R¹ is a divalent group selected from the group consisting of hydrocarbon groups having 2 to 20 carbon atoms, where R¹ existing in plural numbers may be the same with or different from each other;
R² is a hydrogen atom or a monovalent group selected from the group consisting of hydrocarbon groups having 1 to 5 carbon atoms, where R² existing in plural numbers may be the same with or different from each other;
x and y represent a copolymerization ratio and are a real number satisfying 5/95 ≤ y/x ≤ 95/5, where x and y are on a molar basis.

6. The resin composition according to any one of Claims 1 to 5,
wherein the soft copolymer (B) is a soft copolymer obtained by polymerizing at least two kinds of monomers selected from the group consisting of ethylene and α-olefins having 3 to 20 carbon atoms.

7. The resin composition according to any one of Claims 1 to 6,
wherein the nonionic antistatic agent (E) is at least one or more kinds selected from the group consisting of polyoxyethylene alkyl ethers, polyoxyethylene alkylphenyl ethers, polyoxyethylene alkyl amines, polyoxyethylene alkyl amides, polyoxyethylene sorbitan alkyl esters, glycerin fatty acid ester, and sorbitan fatty acid ester.

8. The resin composition according to any one of Claims 1 to 6,
wherein the anionic antistatic agent (E) is at least one or more kinds selected from the group consisting of alkyl sulfonate, alkyl benzene sulfonate, alkyl naphthalene sulfonate, alkyl diphenyl sulfonate, alkyl phosphate ester, alkyl phosphite, alkylphosphonic acid, and alkylphosphonic acid ester.

9. The resin composition according to any one of Claims 1 to 8, which is prepared by melting and kneading the cyclic olefin polymer (A), the soft copolymer (B), the radical initiator (C), the polyfunctional compound (D), and the nonionic or anionic antistatic agent (E).

10. A container for storing a plate-like product selected from a semiconductor substrate, a display substrate and a recording medium substrate in a clean room or a tool for handling raw materials, intermediate products or end products in a clean room, obtained from the resin composition according to any one of claims 1 to 9.

11. The container or tool according to Claim 10, which has a surface resistivity of 10⁸ to 10¹¹ Ω/cm².

## Patentansprüche

1. Harzzusammensetzung umfassend:
99 bis 30 Gew.-Teile eines cyclischen Olefinpolymers (A); 1 bis 70 Gew.-Teile eines weichen Copolymers (B), erhalten durch Polymerisation von mindestens zwei Monomerarten, ausgewählt aus der Gruppe bestehend aus Olefinen, Dienen, und aromatischen Vinylkohlenwasserstoffen, und mit einer Glasübergangstemperatur von 0°C oder niedriger; und in bezug auf 100 Gew.-Teile der Gesamtmenge des cyclischen Olefinpolymers (A) und des weichen Copolymers (B),
0,001 bis 1 Gew.-Teil eines Radikalinitiators (C),
0 bis 1 Gew.-Teil einer polyfunktionellen Verbindung (D) mit zwei oder mehr radikalpolymerisierbaren funktionellen Gruppen im Molekül, und
0,5 bis 10 Gew.-Teile eines nicht-ionischen oder anionischen antistatischen Mittels (E).

2. Harzzusammensetzung gemäss Anspruch 1,
wobei das cyclische Olefinpolymer (A) ein cyclisches Olefin-Copolymer mit ein oder zwei oder mehr Arten einer Struktur der nachstehenden allgemeinen Formel (1) ist: 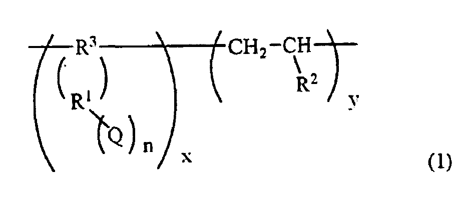 worin
x und y ein Copolymerisationsverhältnis darstellen und eine reelle Zahl sind, die 0/100 ≤ y/x ≤ 95/5 erfüllt, wobei x und y auf molarer Basis sind;
n eine Substitutionszahl einer Substituentengruppe Q darstellt und eine ganze Zahl ist, die 0 ≤ n ≤ 2 erfüllt;
R¹ eine Gruppe mit einer Wertigkeit von 2 + n ist, die aus der Gruppe bestehend aus Kohlenwasserstoffgruppen mit 2 bis 20 Kohlenstoffatomen ausgewählt ist, wobei R¹, das in einer Mehrzahl vorliegt, gleich oder jeweils voneinander verschieden sein kann;
R² ein Wasserstoffatom oder eine einwertige Gruppe ist, ausgewählt aus der Gruppe bestehend aus Kohlenwasserstoffgruppen mit 1 bis 10 Kohlenstoffatomen, die aus einem Kohlenstoffatom und einem Wasserstoffatom zusammengesetzt sind, wobei R², das in einer Mehrzahl vorliegt, gleich oder jeweils voneinander verschieden sein kann;
R³ eine vierwertige Gruppe, ausgewählt aus der Gruppe bestehend aus Kohlenwasserstoffgruppen mit 2 bis 10 Kohlenstoffatomen, ist, wobei R³, das in einer Mehrzahl vorliegt, gleich oder jeweils voneinander verschieden sein kann;
Q durch -COOR⁴ dargestellt ist, wobei Q, das in einer Mehrzahl vorliegt, gleich oder jeweils voneinander verschieden sein kann;
R⁴ ein Wasserstoffatom oder eine einwertige Gruppe ist, ausgewählt aus der Gruppe bestehend aus Kohlenwasserstoffgruppen mit 1 bis 10 Kohlenstoffatomen, die aus Kohlenstoffatomen und Wasserstoffatomen zusammengesetzt sind; und
ein Kreisbogen, der R³ mit R¹ verbindet, eine Bindung zwischen R³ und R¹ darstellt.

3. Harzzusammensetzung gemäss Anspruch 1 oder 2, wobei das cyclische Olefinpolymer (A) eine Glasübergangstemperatur von 60 bis 200°C aufweist.

4. Harzzusammensetzung gemäss irgendeinem der Ansprüche 1 bis 3, wobei das cyclische Olefinpolymer (A) ein cyclisches Olefin-Ringöffnungspolymer oder ein Wasserstoffadditiv davon ist.

5. Harzzusammensetzung gemäss irgendeinem der Ansprüche 1 bis 3, wobei das cyclische Olefinpolymer (A) ein cyclisches Olefin-Copolymer mit ein oder zwei oder mehr Arten einer Struktur der nachstehenden allgemeinen Formel (2) ist: 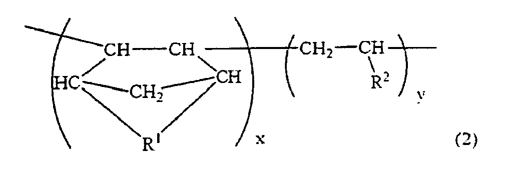 worin R¹ eine zweiwertige Gruppe ist, ausgewählt aus der Gruppe bestehend aus Kohlenwasserstoffgruppen mit 2 bis 20 Kohlenstoffatomen, wobei R¹, das in einer Mehrzahl vorliegt, gleich oder jeweils voneinander verschieden sein kann;
R² ein Wasserstoffatom oder eine einwertige Gruppe ist, ausgewählt aus der Gruppe bestehend aus Kohlenwasserstoffgruppen mit 1 bis 5 Kohlenstoffatomen, wobei R², das in einer Mehrzahl vorliegt, gleich oder jeweils voneinander verschieden sein kann;
x und y ein Copolymerisationsverhältnis darstellen und eine reelle Zahl sind, die 5/95 ≤ y/x ≤ 95/5 erfüllt, wobei x und y auf molarer Basis sind.

6. Harzzusammensetzung gemäss irgendeinem der Ansprüche 1 bis 5, wobei das weiche Copolymer (B) ein weiches Copolymer ist, das durch Polymerisation von mindestens zwei Monomerarten, ausgewählt aus der Gruppe bestehend aus Ethylen und α-Olefinen mit 3 bis 20 Kohlenstoffatomen, erhalten wird.

7. Harzzusammensetzung gemäss irgendeinem der Ansprüche 1 bis 6, wobei das nicht-ionische antistatische Mittel (E) mindestens eine oder mehrere Arten ausgewählt aus der Gruppe bestehend aus Polyoxyethylenalkylethern, Polyoxyethylenalkylphenylethern, Polyoxyethylenalkylaminen, Polyoxyethylenalkylamiden, Polyoxyethylensorbitanalkylestern, Glycerin-Fettsäureester und Sorbitan-Fettsäureester ist.

8. Harzzusammensetzung gemäss irgendeinem der Ansprüche 1 bis 6, wobei das anionische antistatische Mittel (E) mindestens eine oder mehrere Arten ausgewählt aus der Gruppe bestehend aus Alkylsulfonat, Alkylbenzolsulfonat, Alkylnaphthalinsulfonat, Alkyldiphenylsulfonat, Alkylphosphatester, Alkylphosphit, Alkylphosphonsäure und Alkylphosphonsäureester ist.

9. Harzzusammensetzung gemäss irgendeinem der Ansprüche 1 bis 8, die durch Schmelzen und Kneten des cyclischen Olefinpolymers (A), des weichen Copolymers (B), des Radikalinitiators (C), der polyfunktionellen Verbindung (D) und des nicht-ionischen oder anionischen antistatischen Mittels (E) hergestellt wird.

10. Behälter zur Lagerung eines plattenähnlichen Produkts, ausgewählt aus einem Halbleitersubstrat, einem Displaysubstrat und einem Aufzeichnungsmediumsubstrat, in einem Reinraum, oder Werkzeug für den Umgang mit Rohstoffen, Zwischenprodukten oder Endprodukten in einem Reinraum, erhalten aus der Harzzusammensetzung gemäss irgendeinem der Ansprüche 1 bis 9.

11. Behälter oder Werkzeug gemäss Anspruch 10 mit einem Oberflächenwiderstand von 10⁸ bis 10¹¹ Ω/cm².

## Revendications

1. Composition de résine comprenant:
99 à 30 parties en poids d'un polymère d'oléfine cyclique (A) ; 1 à 70 partie(s) en poids d'un copolymère mou (B) obtenu par polymérisation d'au moins deux espèces de monomères choisies parmi le groupe consistant en des oléfines, des diènes, et des hydrocarbures vinyliques aromatiques, et ayant une température de transition vitreuse de 0°C ou moins ; et pour 100 parties en poids de la quantité totale du polymère d'oléfine cyclique (A) et du copolymère mou (B),
0,001 à 1 partie en poids d'un initiateur radicalaire (C),
0 à 1 partie en poids d'un composé polyfonctionnel (D) ayant deux groupes fonctionnels susceptibles de polymérisation radicalaire ou plus dans une molécule, et
0,5 à 10 partie(s) en poids d'un agent antistatique non ionique ou anionique (E).

2. Composition de résine selon la revendication 1,
dans laquelle le polymère d'oléfine cyclique (A) est un copolymère d'oléfine cyclique ayant une ou deux espèces ou plus d'une structure représentée par la formule générale (1) suivante : 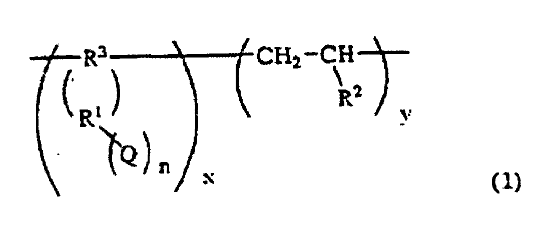
dans laquelle x et y représentent un rapport de copolymérisation et sont un nombre réel satisfaisant à 0/100 ≤ y/x ≤ 95/5, x et y sont sur une base molaire ;
n représente un nombre substitutionnel d'un groupe substituant Q et un entier satisfaisant à 0 ≤ n ≤ 2 ;
R¹ est un groupe ayant une valence de 2 + n, qui est choisi parmi le groupe consistant en des groupes hydrocarbure ayant 2 à 20 atomes de carbone, où des R¹ existant en des nombres multiples peuvent être identiques ou différents les uns des autres ;
R² est un atome d'hydrogène ou un groupe monovalent choisi parmi le groupe consistant en des groupes hydrocarbure ayant 1 à 10 atomes de carbone qui sont composés d'atomes de carbone et d'atomes d'hydrogène, où des R² existant en des nombres multiples peuvent être identiques ou différents les uns des autres ;
R³ est un groupe tétravalent choisi parmi le groupe consistant en des groupes hydrocarbure ayant 2 à 10 atomes de carbone, où des R³ existant en des nombres multiples peuvent être identiques ou différents les uns des autres ;
Q est représenté par -COOR⁴, où des Q existant en des nombres multiples peuvent être identiques ou différents les uns des autres ;
R⁴ est un atome d'hydrogène ou un groupe monovalent choisi parmi le groupe consistant en des groupes hydrocarbure ayant 1 à 10 atomes de carbone qui sont composés d'atomes de carbone et d'atomes d'hydrogène ;
et
un arc circulaire qui relie R³ avec R¹ représente une liaison entre R³ et R¹.

3. Composition de résine selon la revendication 1 ou 2, dans laquelle le polymère d'oléfine cyclique (A) a une température de transition vitreuse de 60 à 200°C.

4. Composition de résine selon l'une quelconque des revendications 1 à 3,
dans laquelle le polymère d'oléfine cyclique (A) est un polymère d'oléfine cyclique à ouverture de cycle ou un additif d'hydrogène de celui-ci.

5. Composition de résine selon l'une quelconque des revendications 1 à 3,
dans laquelle le polymère d'oléfine cyclique (A) est un copolymère d'oléfine cyclique ayant une ou deux espèces ou plus d'une structure représentée par la formule générale (2) suivante : 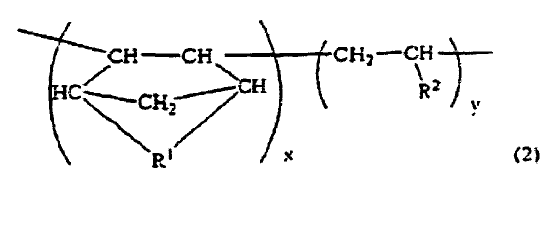 dans laquelle R¹ est un groupe divalent choisi parmi le groupe consistant en des groupes hydrocarbure ayant 2 à 20 atomes de carbone, où des R¹ existant en des nombres multiples peuvent être identiques ou différents les uns des autres ;
R² est un atome d'hydrogène ou un groupe monovalent choisi parmi le groupe consistant en des groupes hydrocarbure ayant 1 à 5 atomes de carbone, où des R² existant en des nombres multiples peuvent être identiques ou différents les uns des autres ;
x et y représentent un rapport de copolymérisation et sont un nombre réel satisfaisant à 5/95 ≤ y/x ≤ 95/5, où x et y sont sur une base molaire.

6. Composition de résine selon l'une quelconque des revendications 1 à 5,
dans laquelle le copolymère mou (B) est un copolymère mou obtenu par polymérisation d'au moins deux espèces de monomères choisies parmi le groupe consistant en l'éthylène et des α-oléfines ayant 3 à 20 atomes de carbone.

7. Composition de résine selon l'une quelconque des revendications 1 à 6,
dans laquelle l'agent antistatique non ionique (E) est au moins une ou plusieurs espèce(s) choisie(s) parmi le groupe consistant en des éthers alkyliques de polyoxyéthylène, des éthers alkylphényliques de polyoxyéthylène, des polyoxyéthylène alkylamines, des polyoxyéthylène alkylamides, des esters alkyliques de polyoxyéthylène sorbitan, un ester d'acide gras de glycérine, et un ester d'acide gras de sorbitan.

8. Composition de résine selon l'une quelconque des revendications 1 à 6,
dans laquelle l'agent antistatique anionique (E) est au moins une ou plusieurs espèce(s) choisie(s) parmi le groupe consistant en un sulfonate d'alkyle, un benzènesulfonate d'alkyle, un naphtalènesulfonate d'alkyle, un diphénylsulfonate d'alkyle, un ester de phosphate d'alkyle, un phosphite d'alkyle, un acide alkylphosphonique, et un ester d'acide alkylphosphonique.

9. Composition de résine selon l'une quelconque des revendications 1 à 8, qui est préparée par fusion et malaxage du polymère d'oléfine cyclique (A), du copolymère mou (B), de l'initiateur radicalaire (C), du composé polyfonctionnel (D), et de l'agent antistatique non ionique ou anionique (E).

10. Récipient destiné au stockage d'un produit de type plaque choisi parmi un substrat semi-conducteur, un substrat d'affichage et un substrat de support d'enregistrement dans une salle blanche, ou outil pour manipuler des matières premières, des produits intermédiaires ou des produits finals dans une salle blanche, obtenu à partir de la composition de résine selon l'une quelconque des revendications 1 à 9.

11. Récipient ou outil selon la revendication 10, qui a une résistivité de surface de 10⁸ à 10¹¹ Ω/cm².
